# EUROPEAN PATENT APPLICATION

(11) **EP 4 697 902 A1**
(43) Date of publication of application: **18.02.2026**
(21) Application number: 25799473.1
(22) Date of filing: 28.04.2025
(51) Int. Cl.: H10F 77/20

(54) **BACK CONTACT CELL AND PREPARATION METHOD THEREFOR**

(30) Priority: 14.06.2024 CN 202410772492; 14.06.2024 CN 202410772306
(71) Applicant: LONGi Green Energy Technology Co., Ltd., Xi'an, Shaanxi 710100 (CN)
(72) Inventor: TANG, Qing, Xi'an, Shaanxi 710100 (CN); XU, Qishu, Xi'an, Shaanxi 710100 (CN); YIN, Shi, Xi'an, Shaanxi 710100 (CN); YE, Feng, Xi'an, Shaanxi 710100 (CN); FANG, Liang, Xi'an, Shaanxi 710100 (CN)
(74) Representative: Pfenning, Meinig & Partner mbB
(86) International application number: PCT/CN2025/091866
(87) International publication number: WO 2025/256285

(57) **Abstract**

The present application discloses a back contact cell and a method for manufacturing same. The back contact cell includes a silicon substrate. A plurality of first regions and a plurality of second regions are sequentially and alternately disposed on a back surface of the silicon substrate. A first semiconductor layer is disposed on each of the first regions. A second semiconductor layer is disposed on each of the second regions. The first semiconductor layer is connected to a first transparent electrode pattern. The second semiconductor layer is connected to a second transparent electrode pattern. The first transparent electrode pattern and the second transparent electrode pattern are consistently isolated by a first gap. The foregoing solution can improve the conversion efficiency of the back contact cell.

## Description

The present application claims priority to Chinese Patent Application No. 202410772492X filed with the China National Intellectual Property Administration on June 14, 2024 and entitled "BACK CONTACT CELL AND METHOD FOR MANUFACTURING SAME", and Chinese Patent Application No. 202410772306.2 filed with the China National Intellectual Property Administration on June 14, 2024 and entitled "BACK CONTACT PHOTOVOLTAIC CELL AND METHOD FOR MANUFACTURING SAME", which are incorporated herein by reference in their entireties.

### TECHNICAL FIELD

The present application generally relates to the field of photovoltaic technologies, and specifically, to a back contact cell and a method for manufacturing same.

### BACKGROUND

In a back contact (Interdigitated Back Contact, IBC) cell technology, electrodes on a front surface of a cell are moved to a back surface, and no gate line is disposed on the front surface, thereby eliminating shading of light by a gate line. Therefore, a back contact cell has high conversion efficiency. Currently, photoelectric conversion efficiency may generally reach more than 25%. However, in the related art, there is usually a leakage current problem between a P region and an N region of a back contact cell. To solve the leakage current problem, research and development technical personnel add a complex isolation structure, which additionally generates more process steps, leading to an increase in the manufacturing costs of the cell. Therefore, how to search for a back contact cell that can not only reduce leakage current and improve the photoelectric conversion efficiency of the cell but also simplify a manufacturing process of the cell becomes a great challenge to be solved urgently in the photovoltaic industry.

### SUMMARY

The present application provides a back contact cell, which improves the conversion efficiency of the back contact cell by taking both structural optimization and leakage current reduction into consideration.

According to a first aspect, the present application provides a back contact cell, including a silicon substrate, where the silicon substrate includes a front surface and a back surface; and a plurality of first regions and a plurality of second regions are sequentially and alternately disposed on the back surface of the silicon substrate, a first semiconductor layer is disposed on each of the first regions, a second semiconductor layer is disposed on each of the second regions,
the first semiconductor layer is connected to a first transparent electrode pattern, the second semiconductor layer is connected to a second transparent electrode pattern, and the first transparent electrode pattern and the second transparent electrode pattern are consistently isolated by a first gap.

In the foregoing solution, the first gap is disposed to ensure the physical isolation between the transparent electrode patterns in P and N regions of the back contact cell, thereby achieving the technical effect of isolating the first semiconductor layer from the second semiconductor layer, avoiding the generation of leakage current, and improving the photoelectric conversion effect of the cell.

In some possible embodiments, the second semiconductor layer extends toward the first region relative to the second region, and sequentially includes a climbing portion and a covering portion, and the covering portion covers a portion of the first semiconductor layer to form a bare first semiconductor region and a covered first semiconductor region;
the second transparent electrode pattern is disposed on a portion of the second semiconductor layer, a portion of the climbing portion, and a portion of the covering portion above an orthographic projection of the second region; and
the first transparent electrode pattern is disposed on the bare first semiconductor region and a portion of the covering portion in a direction perpendicular to a direction in which the first region extends toward the second region.

The electrode patterns are disposed on the surface of a portion of the covering portion, i.e., the transparent electrode pattern layer is etched away from the surface of a portion of the covering portion. In this way, the range of passivation is expanded as much as possible in terms of the passivation of a transparent electrode pattern layer, thereby avoiding a recombination problem caused by poor lateral transport in this portion of the semiconductor layer. Moreover, the first transparent electrode pattern and the second transparent electrode pattern partially cover the portion of the second semiconductor layer, the portion of the climbing portion, and the portion of the covering portion above the orthographic projection of the second region. Moreover, a position from the second region to the climbing portion and a position from the climbing portion to the covering portion are deformation positions, and therefore film forming structures of the transparent electrode patterns at the positions are also easily deformable structures. Compared with the whole cell, under the action of external force and stress in the cell, the foregoing positions are more easily deformable. Therefore, partially covering transparent electrode patterns are disposed at the foregoing positions, so that stress on the transparent electrode patterns can be effectively reduced and released, thereby reducing probabilities of peeling, delamination, and edge chipping of the transparent electrode patterns. In another aspect, a laminated structure in which the first semiconductor layer, the second semiconductor layer, and the transparent electrode pattern are sequentially stacked is formed at a position of only a portion of the covering portion, and may be used as an anti-hot spot leakage channel. However, when the anti-hot spot leakage channel is excessively large, a leakage current problem easily occurs, and photoelectric conversion efficiency is reduced. Therefore, in the present application, instead of fully covering the covering portion, the second transparent electrode pattern and the first transparent electrode pattern only partially cover the covering portion and form wavy transparent electrode patterns. Therefore, the formed anti-hot spot leakage channel is kept from becoming excessively large, so that a leakage current problem is avoided. In addition, an anti-hot spot leakage effect can be ensured, and the photoelectric conversion efficiency is basically not affected.

In some possible embodiments, the first transparent electrode pattern includes a first middle region and a first peripheral region surrounding the first middle region, and a thickness of the first peripheral region is less than an average thickness of the first middle region; and/or
the second transparent electrode pattern includes a second middle region and a second peripheral region surrounding the second middle region, and a thickness of the second peripheral region is less than an average thickness of the second middle region.

In the foregoing solution, a thickness of a peripheral region of a transparent electrode pattern is less than a thickness of a middle region of the transparent electrode pattern, so that it can be ensured that a binding force of the transparent electrode pattern is applied in the middle region of a transparent electrode. If a local pulling force change occurs in the peripheral region, because the peripheral region is thin, the pulling force change in the peripheral region does not greatly affect the middle region. Due to the pulling force change in the peripheral region, a lateral pulling force generated in the peripheral region can only be automatically stretched in the peripheral region, or even if micro-cracking occurs, micro-cracking is confined in the peripheral region without propagating to the middle region, thereby ensuring the lateral transport performance of the cell.

In some possible embodiments, the first transparent electrode pattern includes a first middle region and a first peripheral region surrounding the first middle region, and in a cross-section of the back contact cell, a thickness of the first peripheral region gradually increases along a direction away from an edge of the first peripheral region; and/or
the second transparent electrode pattern includes a second middle region and a second peripheral region surrounding the second middle region, and in a cross-section of the back contact cell, a thickness of the second peripheral region gradually increases along a direction away from an edge of the second peripheral region.

In the foregoing solution, a thickness of a peripheral region gradually increases along a direction away from an edge of the peripheral region, so that it can be linearly ensured that a binding force of the transparent electrode pattern is applied in the middle region of a transparent electrode. If a local pulling force change occurs in the peripheral region, because the peripheral region is thin, the pulling force change in the peripheral region does not greatly affect the middle region. Due to the pulling force change in the peripheral region, a lateral pulling force generated in the peripheral region can only be automatically and linearly stretched in the peripheral region, or even if micro-cracking occurs, linear micro-cracking is confined in the peripheral region without directly propagating to the middle region, thereby ensuring the lateral transport performance of the cell.

In some possible embodiments, the first transparent electrode pattern includes a first middle region and a first peripheral region surrounding the first middle region, a first thickness-reduced region is disposed in the first peripheral region of the first transparent electrode pattern, and a thickness of the first thickness-reduced region gradually decreases from a middle region of the first transparent electrode pattern to an outer boundary of the first transparent electrode pattern; and/or
the second transparent electrode pattern includes a second middle region and a second peripheral region surrounding the second middle region, a second thickness-reduced region is disposed in the second peripheral region of the second transparent electrode pattern, and a thickness of the second thickness-reduced region gradually decreases from a middle region of the second transparent electrode pattern to an outer boundary of the second transparent electrode pattern.

In the foregoing solution, a thickness of a peripheral region gradually increases along a direction away from an edge of the peripheral region, so that it can be linearly ensured that a binding force of the transparent electrode pattern is applied in the middle region of a transparent electrode. If a local pulling force change occurs in the peripheral region, because the peripheral region is thin, the pulling force change in the peripheral region does not greatly affect the middle region. Due to the pulling force change in the peripheral region, a lateral pulling force generated in the peripheral region can only be automatically and linearly stretched in the peripheral region, or even if micro-cracking occurs, linear micro-cracking is confined in the peripheral region without directly propagating to the middle region, thereby ensuring the lateral transport performance of the cell.

In some possible embodiments, when the second transparent electrode pattern is disposed on the portion of the second semiconductor layer above the orthographic projection of the second region, a second gap is formed between an edge of the second transparent electrode pattern and the climbing portion in a cross-section of the back contact cell; and a width of the second gap ranges from 10 micrometers to 80 micrometers in some embodiments, and ranges from 20 micrometers to 50 micrometers in some embodiments.

In the foregoing solution, the second gap is formed between the edge of the second transparent electrode pattern and the climbing portion. In a first aspect, good physical isolation can be implemented, to prevent the generation of leakage current. In a second aspect, the gap between the second transparent electrode pattern and the climbing portion vacates a position at which the silicon substrate is deformed, to avoid peeling off of the second transparent electrode pattern at a position at which deformation is large due to a large phase change. In addition, the width of the second gap is properly controlled based on the deformation amount, and the effect is optimal within this interval.

In some possible embodiments, a third gap is formed between an edge of the first transparent electrode pattern and the climbing portion, and a width of the third gap ranges from 40 micrometers to 80 micrometers in some embodiments, and ranges from 40 micrometers to 60 micrometers in some embodiments.

In the foregoing solution, the third gap is formed between the edge of the first transparent electrode pattern and the climbing portion. In a first aspect, good physical isolation can be implemented, to prevent the generation of leakage current. In a second aspect, the gap between the first transparent electrode pattern and the climbing portion vacates a position at which the silicon substrate is deformed, to avoid peeling off of the first transparent electrode pattern at a position at which deformation is large due to a large phase change. In addition, the width of the third gap is properly controlled based on the deformation amount, and the effect is optimal within this interval.

In some possible embodiments, a ratio of the width of the third gap to the width of the second gap ranges from 1:1 to 3:1.

In the foregoing solution, the width of the second gap plus the width of the third gap is the width of the first gap between the first transparent electrode pattern and the second transparent electrode pattern. Therefore, when the isolation effect is ensured without further enlarging the first gap, the third gap is in an overlapping region of the first semiconductor layer and the second semiconductor layer of the back contact cell, and this overlapping region is a dead zone for vertical transport. Therefore, in this portion, the width of the third gap may be increased, and the width of the second gap is correspondingly adjusted and reduced, to control the total width of the first gap to be within an appropriate range. Further, when the ratio of the width of the third gap to the width of the second gap ranges from 1:1 to 3:1, within a particular range of the first gap, i.e., within a range of 60 micrometers to 120 micrometers of the first gap, the smallest third gap can maximize a current collection area while ensuring an isolation effect and isolating an open process window, to increase a fill factor of the cell, thereby further improving the photoelectric conversion efficiency.

In some possible embodiments, a width of the covering portion ranges from 60 micrometers to 200 micrometers, and in some embodiments, ranges from 60 micrometers to 80 micrometers.

In the back contact cell, the covering portion is an overlapping region of the first semiconductor layer and the second semiconductor layer, and this overlapping region is a dead zone for vertical transport. To achieve maximum power generation efficiency, it is expected to reduce the width of the dead zone. However, if the dead zone is completely eliminated, the first semiconductor layer is independently formed at the joint of the climbing portion and the covering portion. Because the etching of the silicon substrate at the joint of the climbing portion and the covering portion is formed during an alkaline texturing process, the edge of the joint of the climbing portion and the covering portion is not a straight line in the direction perpendicular to the direction in which the first region extends toward the second region. The climbing portion generates curves due to different texturing rates, and a bare silicon substrate appears. To passivate the bare silicon substrate, the second semiconductor layer covers the bare portion of the first region, and the width of the covering portion is set to the foregoing range.

In some possible embodiments, a ratio of the width of the covering portion to the width of the third gap ranges from 4:3 to 4:2.

When the ratio of the width of the covering portion to the width of the third gap is 4:3, the largest third gap is achieved. In this case, through etching paste or laser etching, the remaining transparent conductive layer on the covering portion is a portion satisfying a requirement on a process window. The portion remains on the covering portion, to avoid damage of the transparent conductive layer on the effective power generation area of the bare first semiconductor region. In addition, with particular widths of the covering portion and the third gap, the width of the covering portion is reduced to reduce a transport path of holes or electrons of the first semiconductor layer under the covering portion, thereby reducing bulk recombination and improving the power generation efficiency.

In some possible embodiments, a vertical distance between a surface of the covering portion that faces away from the silicon substrate and a position on the silicon substrate is greater than a vertical distance between a surface of the second transparent electrode pattern that faces away from the silicon substrate and a position on the silicon substrate.

Through the foregoing arrangement, i.e., with the front surface of the silicon substrate as a reference, the surface of the covering portion is arranged to be higher than the surface of the second transparent electrode pattern, to ensure that a spacing exists between the first transparent electrode pattern and the second transparent electrode pattern on the surface of the covering portion, thereby further reducing the generation of leakage current.

In some possible embodiments, the first semiconductor layer includes a tunneling layer disposed on the silicon substrate, and an N-type doped polycrystalline silicon layer is disposed on a side of the tunneling layer that faces away from the silicon substrate; and
the second semiconductor layer includes an intrinsic amorphous silicon layer, and a P-type doped microcrystalline silicon layer is disposed on a side of the intrinsic amorphous silicon layer that faces away from the silicon substrate.

Through the foregoing arrangement solution, in one aspect, the tunneling layer and the N-type polycrystalline silicon layer are arranged, so that the electrical conduction performance of the first semiconductor layer is improved, and the electrical conduction performance of the polycrystalline silicon is stronger. In another aspect, the intrinsic amorphous silicon layer and the doped microcrystalline silicon layer are disposed, so that a low-temperature process can be used, thereby reducing process complexity. In addition, the low-temperature process does not affect the performance of the tunneling layer and the N-type polycrystalline silicon layer in the previous step, and the impact of impurity diffusion of a doped element caused by a secondary high temperature is avoided. Third, the intrinsic amorphous silicon layer extends to the first semiconductor layer to form the covering portion, to further passivate the surface of the N-type polycrystalline silicon layer, thereby reducing recombination. Meanwhile, the P-type doped microcrystalline silicon layer is disposed. On the intrinsic amorphous silicon layer, due to the isolation and passivation effects of the intrinsic amorphous silicon layer and the electrical conductivity of the low-temperature P-type doped microcrystalline silicon layer, the current breakdown, short circuit, and leakage between the P and N-type semiconductor layers are prevented.

In some possible embodiments, a textured surface is disposed on the front surface of the silicon substrate, and an intrinsic amorphous silicon layer is disposed on the textured surface, or an aluminum oxide layer is disposed on the textured surface.

Through the foregoing arrangement solution, the front surface of the silicon substrate can be passivated to reduce recombination. In another aspect, the front intrinsic amorphous silicon layer and the aluminum oxide layer have stable performance, so that the service life of the cell can be prolonged.

In some possible embodiments, an anti-reflection layer is disposed on a surface of the intrinsic amorphous silicon layer that faces away from the silicon substrate, or an anti-reflection layer is disposed on a surface of the aluminum oxide layer that faces away from the silicon substrate.

Through the foregoing arrangement solution, the reflection of sunlight is reduced, and the utilization of sunlight is improved, so that the conversion efficiency of the back contact cell can be improved.

In some possible embodiments, the climbing portion is disposed obliquely relative to the back surface of the silicon substrate, and an inclination angle of the climbing portion relative to the back surface of the silicon substrate ranges from 5° to 80° in some embodiments, and ranges from 30° to 70° in some embodiments.

Through the foregoing arrangement solution, the climbing portion is obliquely disposed on the back surface of the silicon substrate, thereby improving the uniformity of depositing intrinsic amorphous silicon, and improving the passivation effect on the semiconductor substrate. In addition, because the deposited intrinsic amorphous silicon layer has good uniformity and better conformality of surface topography, the deposition and manufacturing of the doped amorphous silicon layer is facilitated, and a doped amorphous silicon layer having good electrical performance is formed, thereby also improving the conversion efficiency of the cell.

In some possible embodiments, the first transparent electrode pattern is close to an edge of the first gap, and an edge of the first transparent electrode pattern in a direction perpendicular to a direction in which the first region extends toward the second region has a wavy shape; and/or
the second transparent electrode pattern is close to an edge of the first gap, and an edge of the second transparent electrode pattern in the direction perpendicular to the direction in which the first region extends toward the second region has a wavy shape.

Through the foregoing arrangement solution, the edge of the transparent electrode pattern layer is disposed to have a wavy shape, so that stress in the edge of the transparent electrode pattern can be reduced, and micro-cracking of the transparent electrode pattern caused by a stress change in the silicon substrate on the edge can be kept from affecting lateral transport performance.

In some possible embodiments, an edge of the first transparent electrode pattern in a direction perpendicular to a direction in which the first region extends toward the second region has a wavy shape.

Through the foregoing arrangement solution, the edge of the transparent electrode pattern layer is disposed to have a wavy shape, so that stress in the edge of the transparent electrode pattern can be reduced, and micro-cracking of the transparent electrode pattern caused by a stress change in the silicon substrate on the edge can be kept from affecting lateral transport performance.

In some possible embodiments, an edge of the second transparent electrode pattern in the direction perpendicular to the direction in which the first region extends toward the second region has a wavy shape.

Through the foregoing arrangement solution, the edge of the transparent electrode pattern layer is disposed to have a wavy shape, so that stress in the edge of the transparent electrode pattern can be reduced, and micro-cracking of the transparent electrode pattern caused by a stress change in the silicon substrate on the edge can be kept from affecting lateral transport performance.

In some possible embodiments, a boundary line between the first region and the second region is a curve, so that stress in an edge at a boundary between the first region and the second region can be reduced, to avoid micro-cracking of a layer structure on the edge that is caused by a stress change in the silicon substrate.

In some possible embodiments, the first semiconductor layer and the silicon substrate that are adjacent define a first groove, the second region is a groove region, a valley portion of a bottom textured surface of the groove region is provided with TCO islands, and the TCO islands are away from the climbing portion and are isolated from the climbing portion.

Through the foregoing arrangement solution, the TCO islands are disposed in the valley portion of the bottom textured surface of the groove of the second region. In one aspect, the TCO islands are not electrically connected to the second transparent electrode pattern, thereby ensuring an isolation effect and preventing leakage. In another aspect, the TCO islands fill the valley of the textured surface, so that the surface of the back surface of the cell is flatter, and the reflectivity of the back surface is improved, thereby improving the photoelectric conversion effect.

In some possible embodiments, a side of the first transparent electrode pattern that is close to the first gap has a thickness-reduced region, a width of the thickness-reduced region ranges from 10 µm to 50 µm, and a thickness of an edge of the thickness-reduced region that is close to the first gap ranges from 45 nm to 65 nm.

According to a second aspect, the present application provides a method for manufacturing the foregoing back contact cell, including the following steps:
providing a cell precursor, where the cell precursor includes a silicon substrate, and the silicon substrate includes a front surface and a back surface; and a plurality of first regions and a plurality of second regions are sequentially and alternately disposed on the back surface of the silicon substrate, a first semiconductor layer is disposed on each of the first regions, and a second semiconductor layer is disposed on each of the second regions;
forming a transparent electrode thin film on the back surface of the cell precursor; and
etching the transparent electrode thin film between the first region and the second region to etch the transparent electrode thin film to form a first transparent electrode pattern and a second transparent electrode pattern that are isolated.

The above description is only an overview of the technical solutions of the present application. For a clearer understanding of the technical measure of the present application and implementation according to the content of the specification, and to make the above and other objectives, features, and advantages of the present application clearer and more comprehensible, specific embodiments of the present application are described below.

### BRIEF DESCRIPTION OF THE DRAWINGS

To describe the technical solutions in the embodiments of the present application or the related art more clearly, the following briefly introduces the accompanying drawings required for describing the embodiments or the related art. Apparently, the accompanying drawings in the following description show some embodiments of the present application, and persons of ordinary skill in the art may still derive other drawings from these accompanying drawings without creative efforts.
FIG. 1 is a rear view of a back contact cell according to an embodiment of the present application;
FIG. 2 is a cross-sectional view along A-A in FIG. 1;
FIG. 3 is a cross-sectional view along C-C in FIG. 1;
FIG. 4 is a rear view of a back contact cell according to another embodiment of the present application;

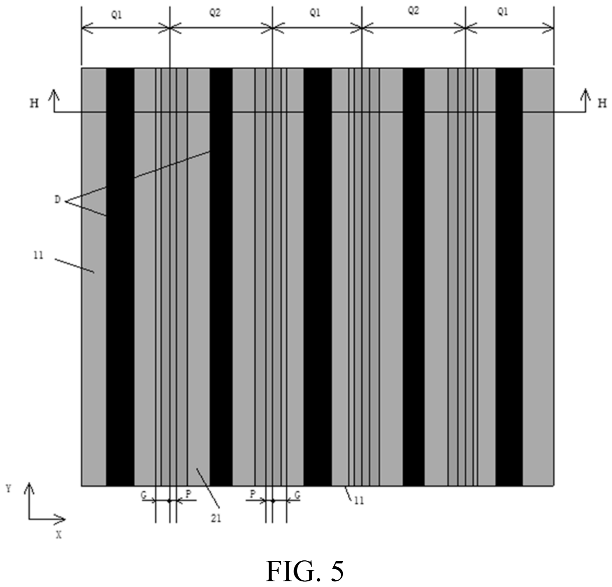

FIG. 5 is a rear view of a back contact cell according to another embodiment of the present application;
FIG. 6 is a rear view of a back contact cell according to another embodiment of the present application;
FIG. 7 is a rear view of a back contact cell according to another embodiment of the present application;
FIG. 8 is a cross-sectional view of a back contact cell corresponding to a position A-A in FIG. 1 according to another embodiment of the present application;
FIG. 9 is a rear view of a back contact cell according to another embodiment of the present application;
FIG. 10 to FIG. 18 are schematic structural diagrams of a manufacturing process corresponding to a cross-sectional position E-E in FIG. 9 according to an embodiment of the present application;
FIG. 19 is a cross-sectional view along H-H in FIG. 5;
FIG. 20 is a rear view of a back contact cell according to another embodiment of the present application;

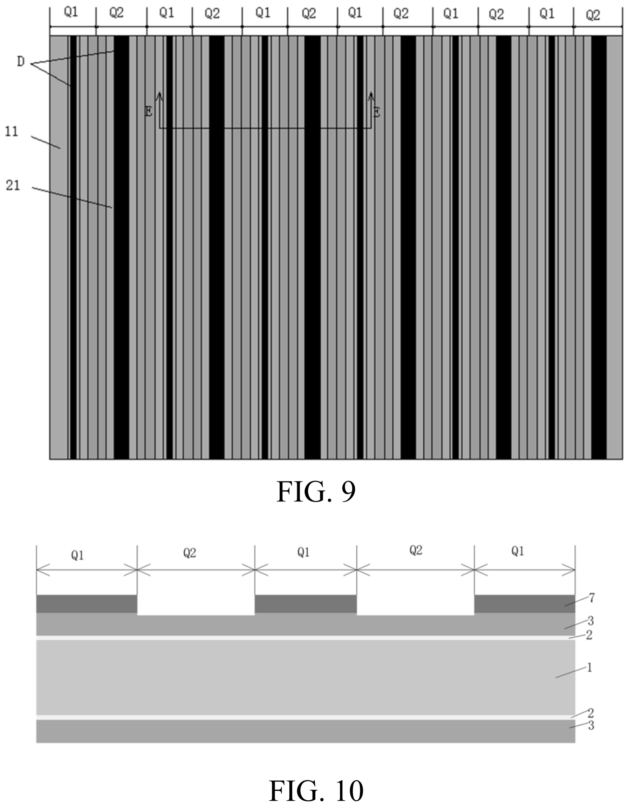

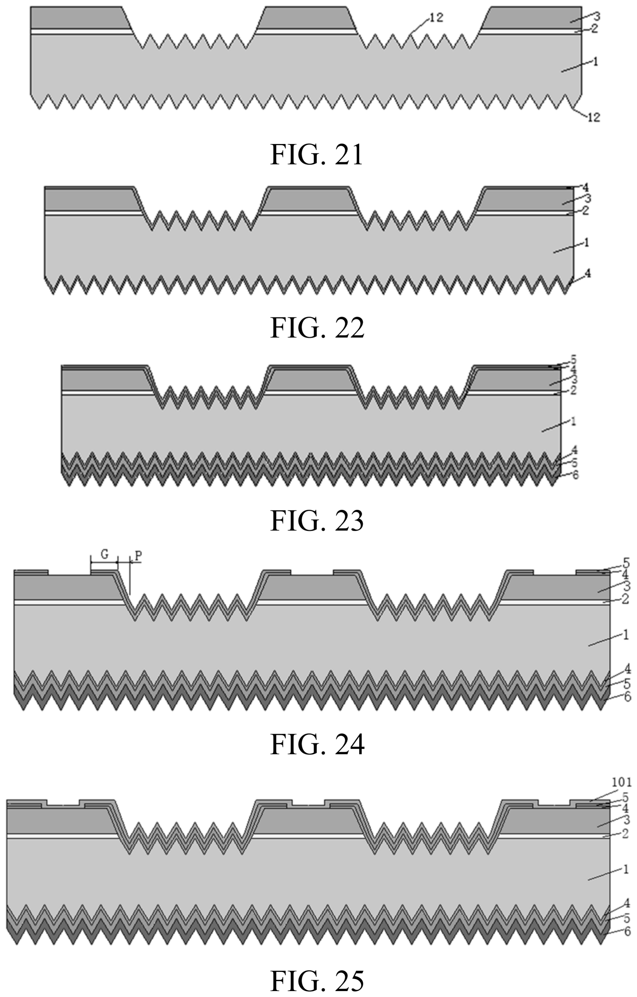

FIG. 10 and FIG. 21 to FIG. 29 are schematic structural diagrams of another manufacturing process corresponding to a cross-sectional position E-E in FIG. 9 according to an embodiment of the present application;

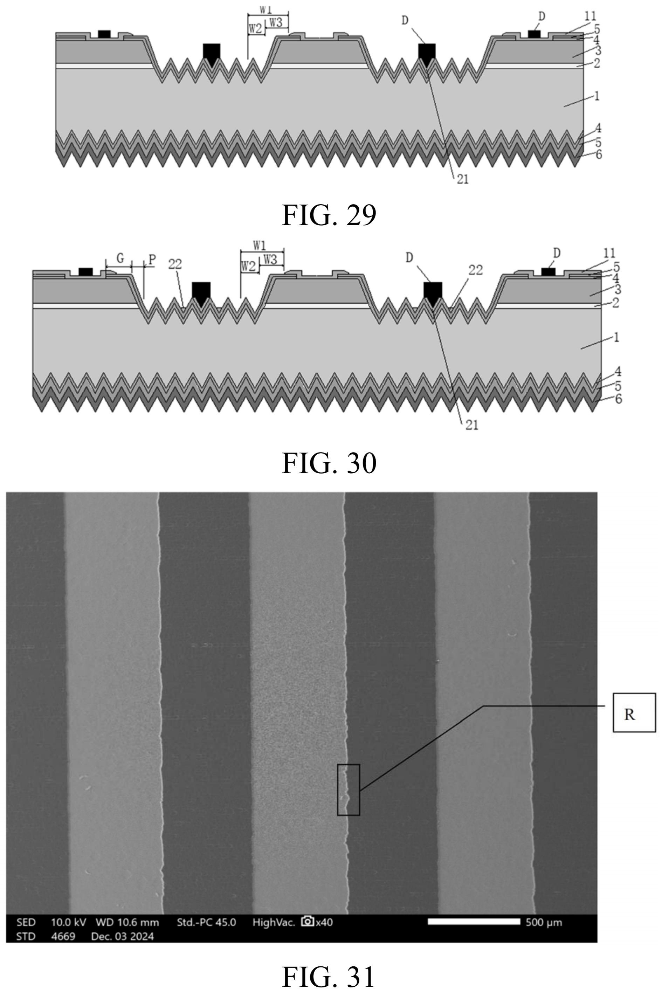

FIG. 30 is a cross-sectional view of a back contact cell corresponding to a position E-E in FIG. 9 according to another embodiment of the present application;
FIG. 31 is a SEM micrograph of a back surface of a back contact cell according to an embodiment of the present application; and

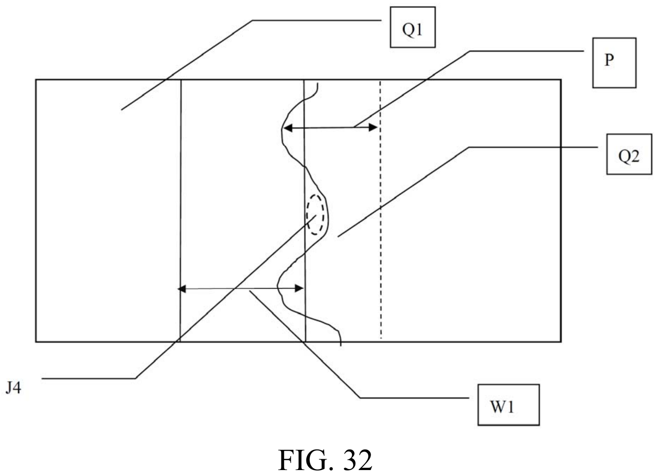

FIG. 32 is a partial enlarged schematic diagram of FIG. 31.

Reference numerals:
N-type silicon substrate 1, first transparent electrode pattern 11, transparent conductive thin film 101, isolating protective layer 102, tunneling layer 2, second transparent electrode pattern 21, N-type polycrystalline silicon layer 3, intrinsic amorphous silicon layer 4, P-type microcrystalline silicon layer 5, anti-reflection layer 6, hydrogenated silicon nitride layer 7, etching paste 8, first region Q1, second region Q2, electrode D, climbing portion P, covering portion G, first gap W1, second gap W2, third gap W3, partial position J1, J2, J3, edge B1, B2, middle region C1, C2, first thickness-reduced region S1, second thickness-reduced region S2, patterned region L, width W4, thickness T1, maximum thinning amount T2, and TCO island 22.

### DETAILED DESCRIPTION

To make the objectives, technical solutions, and advantages of embodiments of the present application clearer, the following clearly and completely describes the technical solutions in embodiments of the present application with reference to the accompanying drawings in embodiments of the present application. It is clear that the described embodiments are merely some rather than all of embodiments of the present application. All other embodiments obtained by a person of ordinary skill in the art based on the embodiments of the present application without creative efforts fall within the protection scope of the present application.

Persons skilled in the art should understand that in the disclosure of the present application, the terms "first", "second", "third", "fourth", "fifth", and the like are only used to distinguish between different structures and do not limit the quantity, connection relationship, or other aspects of specific structures. In addition, orientation or location relationships indicated by terms "up", "down", "front", "rear", "left", "right", "vertical", "horizontal", "top", "bottom", "inside", "outside" are based on orientation or location relationships shown in the accompanying drawings, and are only used to facilitate description of the present application and simplify description, but are not used to indicate or imply that the apparatuses or elements must have specific orientations or are constructed and operated by using specific orientations, and therefore the foregoing terms cannot be understood as a limitation to the present application.

In the embodiments of the present application, if a "patterning process" includes processing such as film layer deposition, photoresist coating, mask exposure, development, etching, and photoresist peeling, the process is a mature manufacturing process in the related art. A "photolithography process" described in this embodiment includes film layer coating, mask exposure, and development, and is a mature manufacturing process in the related art. Deposition may use a known process such as sputtering, evaporation, and chemical vapor deposition, coating may use a known coating process, etching may use a known method, and epitaxial growth may also use a known method. This is not specifically limited herein.

In the description of this embodiment, it should be understood that the "thin film" is a thin film that is made on a substrate by using a material through a deposition, coating, or growth process. If the "thin film" does not require a patterning process or a photolithography process throughout a manufacturing process, the "thin film" may also be referred to as a "layer". If the "thin film" further requires a patterning process or a photolithography process throughout a manufacturing process, the "thin film" is referred to as a "thin film" before the patterning process, and is referred to as a "layer" after the patterning process. A "layer" obtained through a patterning process or a photolithography process includes at least one "pattern". By way of example without constituting any limitation, the thickness of the thin film described herein may be less than 100 µm.

In the related art of solar cells, a selective passivation contact technology separates metal and a semiconductor, thereby avoiding severe recombination caused by direct contact between the metal and the semiconductor. In addition, such a selectively passivated structure is obviously selective to the passage of particular carriers, allowing one type of carriers to pass effectively and having a shielding effect on another type of carriers, to avoid the recombination of the two types of carriers at a collection region of an electrode, thereby effectively improving the photoelectric conversion efficiency of a solar cell device. Typical representatives of the application of such a selectively passivated contact structure to solar technologies are a tunnel oxide passivated contact (TOPCon) solar cell and a heterojunction with intrinsic thin-layer (HIT) solar cell. Both the cell structures are double-sided electrode structures, and a common efficiency bottleneck is that shading caused by metal on a front surface cannot be avoided. For the TOPCon structure, metal is still in direct contact with a silicon base on the front surface. Apart from shading, a severe problem of metal recombination still exists. However, for the HIT structure, although the metal recombination on the front surface is effectively suppressed, the parasitic absorption of incident light by an amorphous silicon/ITO layer causes a severe loss of short-circuit current density.

To mitigate the shading impact on an electrode on the front surface, an interdigitated back contact (IBC) cell technology is developed accordingly. In IBC, an electrode on a front surface of a cell is moved to a back surface, to avoid the shading and recombination of the electrode on the front surface, thereby effectively improving the conversion efficiency of the cell. A Tunnel oxide Back Contact (TBC) or Heterojunction Back Contact (HBC) technology that combines the IBC technology with the TOPCon or HJT technology further reduces the recombination of metal on the back surface of the IBC.

In an n region and a p region on the back surface of the structure of a conventional HBC cell, interdigitated patterns are formed by using a stack structure (i/n a-Si:H for short) of intrinsic amorphous silicon and N-type doped amorphous silicon and a stack structure (i/p a-Si:H for short) of intrinsic amorphous silicon and P-type doped amorphous silicon. Damage to the n region and the p region by laser needs to be strictly controlled in a manufacturing process. Especially for the n region, a process window of laser is narrow, thereby increasing process difficulty. In terms of a manufacturing process, the HBC cell further has the following disadvantages: Because massive masking and demasking techniques, for example, photolithography techniques commonly used in the semiconductor field, are used to form patterns, the production costs is high, and process control is difficult. In terms of fixed investment in equipment, equipment for depositing an amorphous silicon thin film requires high costs and has low production capacity. These aspects limit efficiency improvement and cost reduction of HBC cells, and limit the industrial application of HBC cells.

Because the TOPCon cell technology has matured, a TBC cell that has taken up a key technical process of the TOPCon cell has become a process pathway of an IBC cell with the highest price-performance ratio. SunPower and enterprises in China that attempt to mass-produce IBC cells transform toward the technological pathway. Based on the structure of an IBC cell, for the structure of an n region and a p region on the back surface of the IBC, in TBC, phosphor diffusion and boron diffusion doping in bulk silicon are replaced with a structure of SiOx/n+poly Si and a structure of SiOx/p+poly Si. Such a structure resolves severe metal recombination of the n region and the p region. In addition, such a tunnel oxide passivated contact structure also effectively suppresses a severe Auger recombination problem caused by direct bulk doping of impurities in a conventional IBC structure. However, the TBC cell has the following disadvantages: a long manufacturing process pathway, and high-temperature manufacturing of p poly and n poly causes severe concentric circle defects of a silicon wafer, where the passivation of p poly reaches 10 fA/cm², and n-poly can reach 4 fA/cm². After the interdigitated structure on the back surface is completed, the P region and the N region need to be separately isolated, resulting in a complex manufacturing process.

Therefore, in the technical solution of the present application, a dual passivation technological pathway is used. To be specific, a tunneling layer is used in the N region to perform passivation, and intrinsic silicon is used in the P region to perform passivation.

Specifically, the N region includes a tunneling layer and an N-type doped polycrystalline silicon layer that are laminated. The P region includes an intrinsic amorphous silicon layer and a P-type doped microcrystalline silicon layer that are laminated. The microcrystalline silicon described herein may include a nanocrystalline silicon.

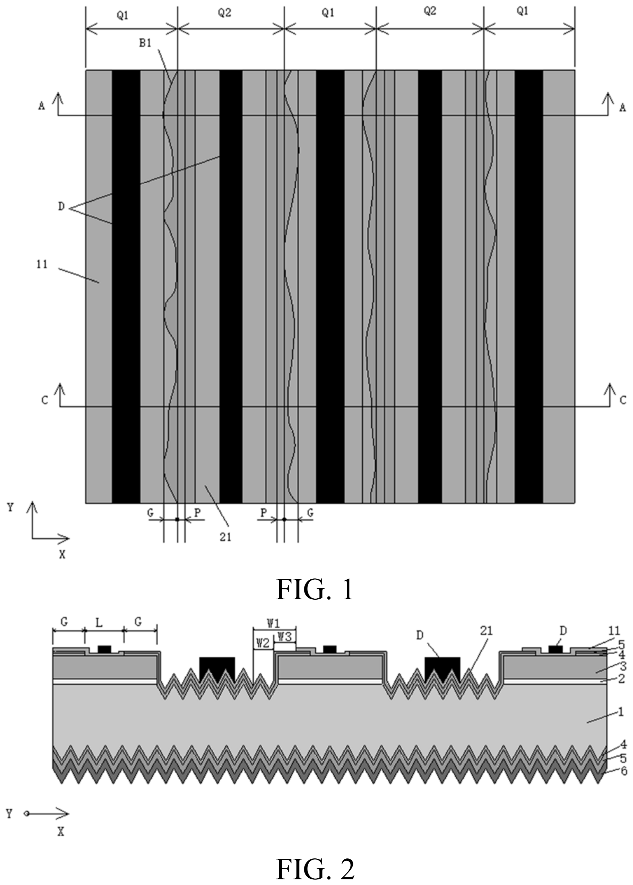

According to a first aspect, as shown in FIG. 1 to FIG. 3, the present application provides a back contact cell, including a silicon substrate. The silicon substrate includes a front surface and a back surface. The front surface described herein may be understood as a surface that faces the sun when the back contact cell is in operation, and the back surface is a surface that is opposite to the front surface.

A plurality of first regions Q1 and a plurality of second regions Q2 are sequentially and alternately disposed on the back surface of the silicon substrate. A first semiconductor layer is disposed on each of the first regions Q1. A second semiconductor layer is disposed on each of the second regions Q2. The second semiconductor layer extends toward the first region Q1 relative to the second region Q2, and sequentially includes a climbing portion P and a covering portion G. The covering portion G covers a portion of the first semiconductor layer to form a bare first semiconductor region and a covered first semiconductor region. The bare first semiconductor region is a portion of the first semiconductor layer that is not covered by the covering portion G. The covered first semiconductor region is a portion of the first semiconductor layer that is covered by the covering portion G.

By way of example without constituting any limitation, an N-type silicon substrate 1 is used as the silicon substrate, and the N-type silicon substrate 1 has a long minority carrier diffusion length, so that photogenerated minority carriers can reach a back junction region without recombination, and are isolated by an electric field in the back junction region to form current.

By way of example without constituting any limitation, the material of the first semiconductor layer includes polycrystalline silicon, and the material of the second semiconductor layer includes microcrystalline silicon.

The polycrystalline silicon may be subjected to N-type doping to form an N-type doped layer, and the microcrystalline silicon may be subjected to P-type doping to form a P-type doped layer. For example, the first semiconductor layer includes, but not limited to, a tunneling layer disposed on the silicon substrate, and an N-type doped polycrystalline silicon layer is disposed on a side of the tunneling layer that faces away from the silicon substrate, and the second semiconductor layer includes, but not limited to, an intrinsic amorphous silicon layer, and a P-type doped microcrystalline silicon layer is disposed on a side of the intrinsic amorphous silicon layer that faces away from the silicon substrate.

In the foregoing solution, the second semiconductor layer extends toward the first region Q1 relative to the second region Q2, and sequentially includes the climbing portion P and the covering portion G. It may be understood that the second semiconductor layer located in the first region Q1, the climbing portion P, and the covering portion G are an integral structure, and the three are manufactured by using a same process and from a same material.

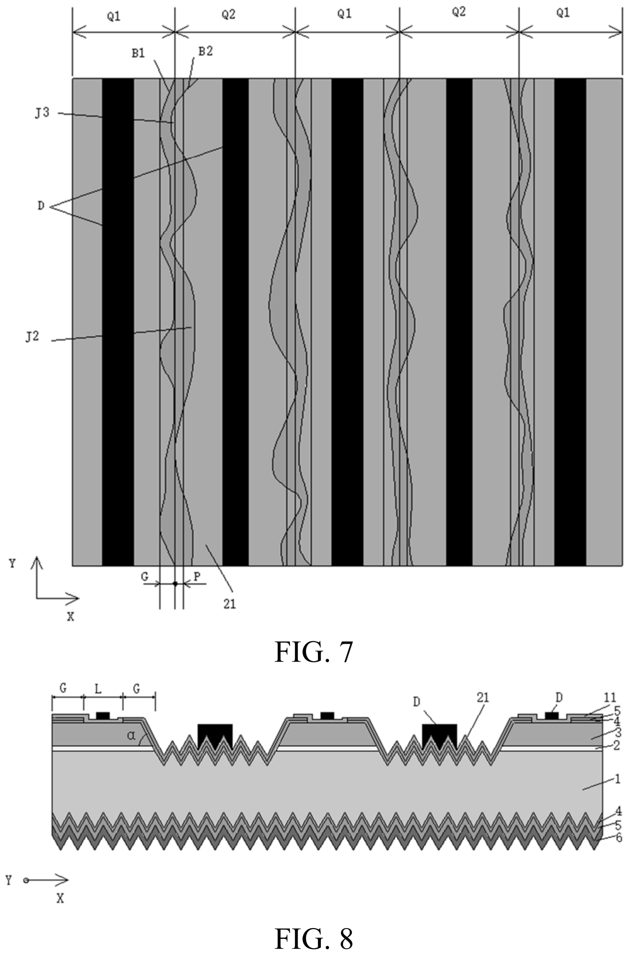

Referring to FIG. 7, the second transparent electrode pattern 21 is disposed on a portion of the second semiconductor layer, a portion of the climbing portion, and a portion of the covering portion above an orthographic projection of the second region Q2.

The first transparent electrode pattern 11 is disposed on the bare first semiconductor region and a portion of the covering portion in a direction perpendicular to a direction in which the first region Q1 extends toward the second region Q2.

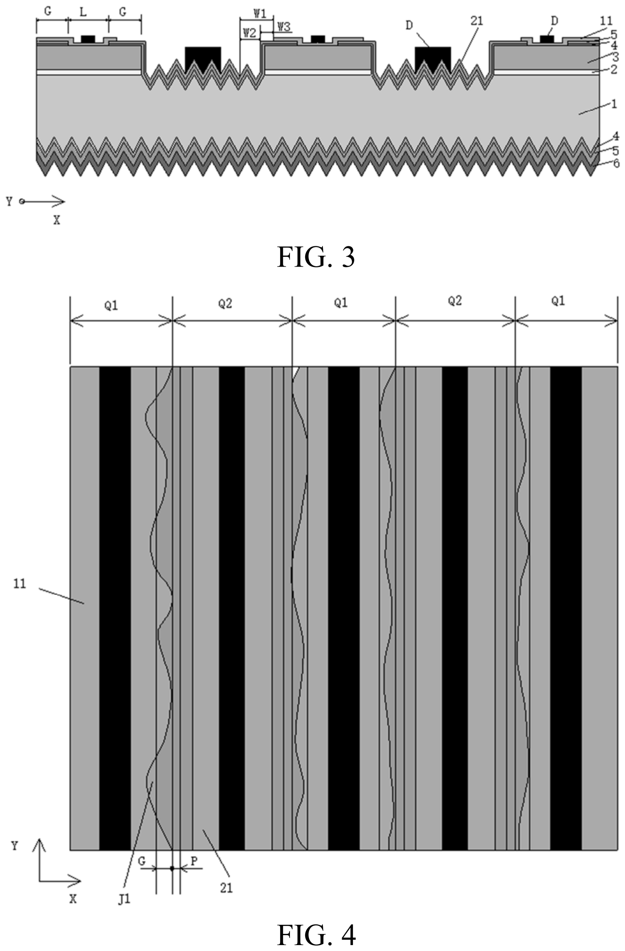

As shown in FIG. 1, the direction in which the first region Q1 extends toward the second region Q2 is an X-axis direction, and the direction perpendicular to the direction in which the first region Q1 extends toward the second region Q2 is a Y-axis direction. In this case, in the Y-axis direction, the first transparent electrode pattern 11 is disposed on a portion of the covering portion. To be specific, in the Y-axis direction, the first transparent electrode pattern 11 is disposed on some portions of the covering portion (further referring to FIG. 3), and the first transparent electrode pattern 11 is not disposed on some other portions of the covering portion (further referring to FIG. 2).

The first transparent electrode pattern 11 and the second transparent electrode pattern 21 are consistently isolated by a first gap W1.

In an embodiment, the width (the dimension in the X-axis direction) of the first gap W1 ranges from 60 micrometers to 120 micrometers, for example, but not limited to, 60 micrometers, 65 micrometers, 70 micrometers, 72 micrometers, 76 micrometers, 80 micrometers, 83 micrometers, 90 micrometers, 97 micrometers, 100 micrometers, 105 micrometers, 110 micrometers, or 120 micrometers.

Materials of the first transparent electrode pattern 11 and the second transparent electrode pattern 21 may be transparent conductive oxides (TCOs). The TCOs include indium tin oxide (ITO), zinc oxide (ZnO), cadmium tin oxide (CTO), aluminum zinc oxide (AZO), indium zinc oxide (IZO), titanium dioxide (TiO₂), indium hydroxide doped (In(OH)₃), indium tungsten oxide (IWO), and the like. In this example, the material of the first transparent electrode pattern 11 and the second transparent electrode pattern 21 is ITO.

The first transparent electrode pattern 11 is connected to the first semiconductor layer. For example, the first transparent electrode pattern 11 of the ITO material is directly disposed on an N-type doped layer of a polycrystalline silicon material. According to specific situations, a contact area between the first transparent electrode pattern 11 and the N-type doped layer of the polycrystalline silicon material may be maximized, to enlarge a current collection region. In addition, because the surface of the polycrystalline silicon has many defects and surface recombination easily occurs, the first transparent electrode pattern 11 is disposed on the surface of the N-type doped layer of the polycrystalline silicon material, and the first transparent electrode pattern 11 can block or reduce recombination centers of the surface defects of the N-type dope layer of the polycrystalline silicon material, thereby reducing the recombination on the surface of the N-type doped layer of the polycrystalline silicon material, and improving the conversion efficiency of the back contact cell.

In addition, as shown in FIG. 4, the arrangement manner of the first transparent electrode pattern 11 may alternatively be that the first transparent electrode pattern 11 is disposed on a portion of the bare first semiconductor region and a portion of the covering portion G.

To be specific, the first transparent electrode pattern 11 is not disposed at a partial position J1 of the bare first semiconductor region, and the first semiconductor layer is exposed at the partial position J1. The first transparent electrode pattern 11 is disposed in some regions of the covering portion G in the X-axis direction and/or the Y-axis direction, and no first transparent electrode pattern 11 is disposed in the remaining regions.

In the foregoing solution, in a first aspect, the first gap W1 is disposed, so that it is ensured that the first transparent electrode pattern 11 and the second transparent electrode pattern 21 are consistently isolated, i.e., the transparent electrode patterns in the P and N regions of the back contact cell are physically isolated. In a second aspect, the electrode patterns are disposed on the surface of a portion of the covering portion G, i.e., the transparent electrode pattern layer is etched away from the surface of a portion of the covering portion G. In this way, the range of passivation is expanded as much as possible in terms of the passivation of a transparent electrode pattern layer, thereby avoiding a recombination problem caused by poor lateral transport in this portion of the semiconductor layer. In a third aspect, the first transparent electrode pattern and the second transparent electrode pattern partially cover the portion of the second semiconductor layer, the portion of the climbing portion, and the portion of the covering portion above the orthographic projection of the second region. Moreover, a position from the second region to the climbing portion and a position from the climbing portion to the covering portion are deformation positions, and therefore film forming structures of the transparent electrode patterns at the positions are also easily deformable structures. Compared with the whole cell, under the action of external force and stress in the cell, the foregoing positions are more easily deformable. Therefore, partially covering transparent electrode patterns are disposed at the foregoing positions, so that stress on the transparent electrode patterns can be effectively reduced and released, thereby reducing probabilities of peeling, delamination, and edge chipping of the transparent electrode patterns. In a fourth aspect, a laminated structure in which the first semiconductor layer, the second semiconductor layer, and the transparent electrode pattern are sequentially stacked is formed at a position of a portion of the covering portion, and may be used as an anti-hot spot leakage channel. However, when the anti-hot spot leakage channel is excessively large, a leakage current problem easily occurs, and photoelectric conversion efficiency is reduced. Therefore, in the present application, the second transparent electrode pattern and the first transparent electrode pattern do not fully cover the covering portion. Therefore, the formed anti-hot spot leakage channel is kept from becoming excessively large, so that a leakage current problem is avoided. In addition, an anti-hot spot leakage effect can be ensured, and the photoelectric conversion efficiency is basically not affected.

The second transparent electrode pattern 21 disposed on a portion of the second semiconductor layer above the orthographic projection of the second region Q2 may adopt at least the following solution:
In an embodiment, at least as shown in FIG. 7, the second transparent electrode pattern 21 is disposed on a portion of the second semiconductor layer, a portion of the climbing portion, and a portion of the covering portion above an orthographic projection of the second region Q2. To be specific, the portion of the second semiconductor layer above the orthographic projection of the second region Q2 is exposed from the second transparent electrode pattern 21. In FIG. 7, the second transparent electrode pattern 21 is not disposed on a partial position J2 above the second semiconductor layer between the two climbing portions P in the second region Q2.

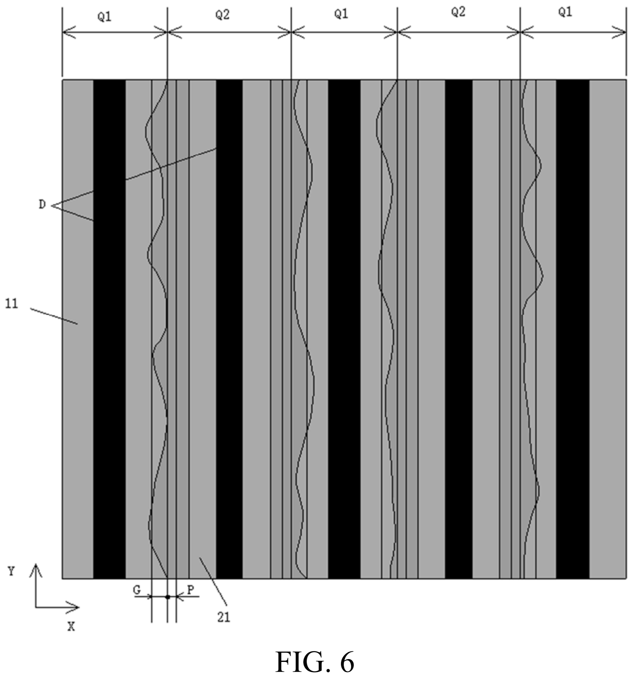

In the example shown in any one of FIG. 1 to FIG. 4, FIG. 6, and FIG. 7, a second gap W2 exists between a boundary of the second transparent electrode pattern 21 and a boundary of the climbing portion P. When the boundary of the second transparent electrode pattern 21 is a non-straight line, the value of the second gap W2 is variable. The second gaps W2 may be equal or not equal according to different positions.

In the foregoing solution, in a process of applying etching paste above the orthographic projection of the second region Q2 or on the covering portion G, to facilitate processing, a process window of the etching paste is enlarged, and a portion of the etching paste is allowed to be etched into the transparent conductive layer above the orthographic projection of the second region Q2, so that the formed second transparent electrode pattern 21 is disposed on the portion of the second semiconductor layer above the orthographic projection of the second region Q2.

In an embodiment, as shown in FIG. 7, the second transparent electrode pattern 21 is disposed on a portion of the second semiconductor layer, a portion of the climbing portion, and a portion of the covering portion G above an orthographic projection of the second region Q2. To be specific, a portion of the second transparent electrode pattern 21 extends to a partial position J3 of the covering portion G, and the second transparent electrode pattern 21 is not disposed on a partial position J2 above the second semiconductor layer between the two climbing portions P in the second region Q2.

In the foregoing solution, in a process of applying etching paste above the orthographic projection of the second region Q2 or on a portion of the covering portion G, to facilitate processing, a process window of the etching paste is enlarged, and a portion of the etching paste is allowed to be etched into the transparent conductive layer above the orthographic projection of the second region Q2, and a portion of the covering portion G is not etched using the etching paste, so that the formed second transparent electrode pattern 21 is disposed on the portion of the second semiconductor layer above the orthographic projection of the second region Q2 and a portion of the covering portion G.

According to the foregoing solution, because the second semiconductor layer extends toward the first region Q1 in the second region Q2 and sequentially includes the climbing portion P and the covering portion G and the covering portion G covers a portion of the first semiconductor layer, the climbing portion is disposed at a boundary between the first region Q1 and the second region Q2, so that the isolation distance between the first transparent electrode pattern and the second transparent electrode pattern can be lengthened, thereby improving isolation performance. The first gap W1 is provided between the first transparent electrode pattern 11 and the second transparent electrode pattern 21, so that the first transparent electrode pattern 11 is disconnected from the second transparent electrode pattern 21, thereby improving an anti-leakage effect between the first region Q1 and the second region Q2. As the anti-leakage effect is improved, the conversion efficiency of the back contact cell is correspondingly improved.

In an embodiment, when the second transparent electrode pattern 21 is disposed on the portion of the second semiconductor layer above the orthographic projection of the second region Q2, a second gap W2 is formed between an edge of the second transparent electrode pattern 21 and the climbing portion P in a cross-section of the back contact cell, for example, in a cross-section at a position A-A in FIG. 1; and a width of the second gap ranges from 10 micrometers to 80 micrometers in some embodiments, for example, but not limited to, 10 micrometers, 15 micrometers, 20 micrometers, 22 micrometers, 26 micrometers, 30 micrometers, 33 micrometers, 40 micrometers, 47 micrometers, 50 micrometers, 55 micrometers, 60 micrometers, 70 micrometers, 73 micrometers, or 80 micrometers, and ranges from 20 micrometers to 50 micrometers in some embodiments.

The second gap W2 is formed between the edge of the second transparent electrode pattern 21 and the climbing portion P. In a first aspect, good physical isolation can be implemented, to prevent the generation of leakage current. In a second aspect, the gap between the second transparent electrode pattern 21 and the climbing portion P vacates a position at which the silicon substrate is deformed, to avoid peeling off of the second transparent electrode pattern 21 at a position at which deformation is large due to a large phase change. In addition, the width W2 of the second gap is properly controlled based on the deformation amount, and the effect is optimal within the foregoing interval.

As an embodiment, a third gap is formed between an edge of the first transparent electrode pattern and the climbing portion, and a width of the third gap ranges from 40 micrometers to 80 micrometers in some embodiments, for example, but not limited to, 40 micrometers, 45 micrometers, 50 micrometers, 52 micrometers, 56 micrometers, 60 micrometers, 63 micrometers, 70 micrometers, or 80 micrometers, and ranges from 40 micrometers to 60 micrometers in some embodiments.

A region of the third gap W3 is located within a range of the covering portion G. Because the region of the covering portion G is a stacked region in which the first semiconductor layer and the second semiconductor layer extend out of the second region Q2, this region is a dead zone of the back contact cell, and carriers cannot be exported from the surface of the second semiconductor layer. Therefore, the width of the third gap W3 can be maximized and the width of the second gap W2 can be minimized when the total first gap W1 is kept unchanged.

In the foregoing solution, the third gap W3 is formed between the edge of the first transparent electrode pattern 11 and the climbing portion P. In a first aspect, good physical isolation can be implemented, to prevent the generation of leakage current. In a second aspect, the gap between the first transparent electrode pattern 11 and the climbing portion P vacates a position at which the silicon substrate is deformed, to avoid peeling off of the first transparent electrode pattern 11 at a position at which deformation is large due to a large phase change. In addition, the width of the third gap W3 is properly controlled based on the deformation amount, and the effect is optimal within this interval.

In an embodiment, a ratio of the width of the third gap W3 to the width of the second gap W2 ranges from 1:1 to 3:1.

In the foregoing solution, the width of the second gap W2 plus the width of the third gap W3 is the width of the first gap W1 between the first transparent electrode pattern 11 and the second transparent electrode pattern 21. Therefore, when the isolation effect is ensured without further enlarging the first gap W1, the third gap W3 is in an overlapping region of the first semiconductor layer and the second semiconductor layer of the back contact cell extending out of the second region Q2, and this overlapping region is a dead zone for vertical transport. Therefore, in this portion, the width of the third gap W3 may be increased, and the width of the second gap W2 is correspondingly adjusted and reduced, to control the total width of the first gap W1 to be within an appropriate range. Further, when the ratio of the width of the third gap W3 to the width of the second gap W2 ranges from 1:1 to 3:1, within a particular range of the first gap W1, i.e., within a range of 60 micrometers to 120 micrometers of the first gap, the smallest third gap W3 can maximize a current collection area while ensuring an isolation effect and isolating an open process window, to increase a fill factor of the cell, thereby further improving the photoelectric conversion efficiency.

In an embodiment, the width of the covering portion G ranges from 60 micrometers to 200 micrometers, ranges from 60 micrometers to 80 micrometers in some embodiments, for example, but not limited to, 60 micrometers, 62 micrometers, 65 micrometers, 68 micrometers, 70 micrometers, 73 micrometers, 75 micrometers, 77 micrometers, 80 micrometers, 100 micrometers, 150 micrometers, or 200 micrometers.

In the back contact cell, the covering portion P is an overlapping region of the first semiconductor layer and the second semiconductor layer, and this overlapping region is a dead zone for vertical transport. To achieve maximum power generation efficiency, it is expected to reduce the width of the dead zone. However, if the dead zone is completely eliminated, the first semiconductor layer is independently formed at the joint of the climbing portion P and the covering portion G. Because the etching of the silicon substrate at the joint of the climbing portion P and the covering portion G is formed during an alkaline texturing process, the edge of the joint of the climbing portion P and the covering portion G is not a straight line in the direction perpendicular to the direction in which the first region Q1 extends toward the second region Q2. The climbing portion generates curves due to different texturing rates, and a bare silicon substrate appears. To passivate the bare silicon substrate, the second semiconductor layer covers the bare portion of the first region Q1, and the width of the covering portion G is set to 60 micrometers to 80 micrometers.

In an implementation, a ratio of the width of the covering portion G to the width of the third gap W3 is between 4:3 to 4:2.

When the ratio of the width of the covering portion G to the width of the third gap W3 is 4:3, the largest third gap W3 is achieved. In this case, through etching paste or laser etching, the remaining transparent conductive layer on the covering portion G is a portion satisfying a requirement on a process window. The portion remains on the covering portion G, to avoid damage of the transparent conductive layer on the effective power generation area of the bare first semiconductor region. In addition, with particular widths of the covering portion G and the third gap W3, the width of the covering portion G is reduced to reduce a transport path of holes or electrons of the first semiconductor layer under the covering portion G, thereby reducing bulk recombination and improving the power generation efficiency.

In an embodiment, a vertical distance between a surface of the covering portion G that faces away from the silicon substrate and a position on the silicon substrate is greater than a vertical distance between a surface of the second transparent electrode pattern 21 that faces away from the silicon substrate and a position on the silicon substrate.

Through the foregoing arrangement, i.e., with the front surface of the silicon substrate as a reference, the surface of the covering portion G is arranged to be higher than the surface of the second transparent electrode pattern 21, to ensure that a spacing exists between the first transparent electrode pattern 11 and the second transparent electrode pattern 21 on the surface of the covering portion G, thereby further reducing the generation of leakage current.

In an embodiment, the first transparent electrode pattern 11 includes a first middle region and a first peripheral region surrounding the first middle region, and a thickness of the first peripheral region is less than an average thickness of the first middle region.

The second transparent electrode pattern 21 includes a second middle region and a second peripheral region surrounding the second middle region, and a thickness of the second peripheral region is less than an average thickness of the second middle region.

Etching paste 8 may be printed at a position of the climbing portion to etch the transparent electrode thin film to form the first transparent electrode pattern 11 and the second transparent electrode pattern 21 that are disconnected from each other. Because the etching paste 8 has particular flowability, a transition region of etching is formed in a first peripheral region of the first transparent electrode pattern 11 and a second peripheral region of the second transparent electrode pattern 21, and a portion of the transparent electrically conductive oxide material in the region is etched away. Therefore, a structure in which the thickness of the first peripheral region is less than the average thickness of the first middle region and the thickness of the second peripheral region is less than the average thickness of the second middle region is formed.

In the foregoing solution, a thickness of a peripheral region of a transparent electrode pattern is less than a thickness of a middle region of the transparent electrode pattern, so that it can be ensured that a binding force of the transparent electrode pattern is applied in the middle region of a transparent electrode. If a local pulling force change occurs in the peripheral region, because the peripheral region is thin, the pulling force change in the peripheral region does not greatly affect the middle region. Due to the pulling force change in the peripheral region, a lateral pulling force generated in the peripheral region can only be automatically stretched in the peripheral region, or even if micro-cracking occurs, micro-cracking is confined in the peripheral region without propagating to the middle region, thereby ensuring the lateral transport performance of the cell.

In an embodiment, the first transparent electrode pattern 11 includes a first middle region and a first peripheral region surrounding the first middle region, and in a cross-section of the back contact cell, a thickness of the first peripheral region gradually increases along a direction away from an edge of the first peripheral region.

The second transparent electrode pattern 21 includes a second middle region and a second peripheral region surrounding the second middle region, and in a cross-section of the back contact cell, a thickness of the second peripheral region gradually increases along a direction away from an edge of the second peripheral region.

In the foregoing solution, a thickness of a peripheral region gradually increases along a direction away from an edge of the peripheral region, so that it can be linearly ensured that a binding force of the transparent electrode pattern is applied in the middle region of a transparent electrode. If a local pulling force change occurs in the peripheral region, because the peripheral region is thin, the pulling force change in the peripheral region does not greatly affect the middle region. Due to the pulling force change in the peripheral region, a lateral pulling force generated in the peripheral region can only be automatically and linearly stretched in the peripheral region, or even if micro-cracking occurs, linear micro-cracking is confined in the peripheral region without directly propagating to the middle region, thereby ensuring the lateral transport performance of the cell.

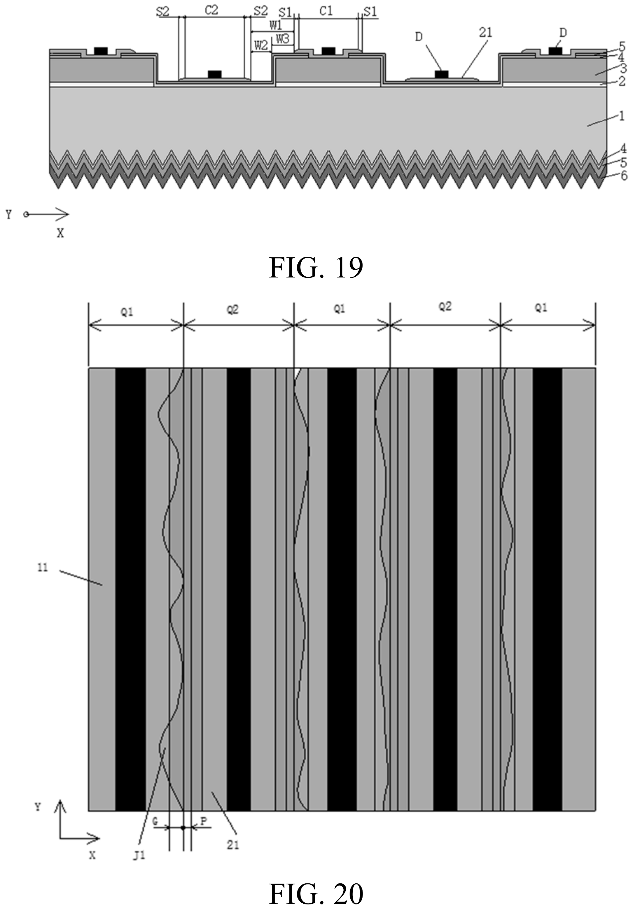

In an embodiment, referring to FIG. 19, the first transparent electrode pattern 11 includes a first middle region and a first peripheral region surrounding the first middle region, a first thickness-reduced region S1 is disposed in the first peripheral region of the first transparent electrode pattern, and a thickness of the first thickness-reduced region S1 gradually decreases from a middle region of the first transparent electrode pattern 11 to an outer boundary of the first transparent electrode pattern 11.

The second transparent electrode pattern 21 includes a second middle region and a second peripheral region surrounding the second middle region, a second thickness-reduced region S2 is disposed in the second peripheral region of the second transparent electrode pattern 21, and a thickness of the second thickness-reduced region S2 gradually decreases from a middle region of the second transparent electrode pattern 21 to an outer boundary of the second transparent electrode pattern 21.

In another example, the first thickness-reduced region S1 may alternatively be disposed only in the first peripheral region of the first transparent electrode pattern 11 that is close to the first gap W1. Alternatively, the second thickness-reduced region S2 may be disposed only in the second peripheral region of the second transparent electrode pattern 21 that is close to the first gap W1.

In the foregoing solution, a thickness of a peripheral region gradually increases along a direction away from an edge of the peripheral region, so that it can be linearly ensured that a binding force of the transparent electrode pattern is applied in the middle region of a transparent electrode. If a local pulling force change occurs in the peripheral region, because the peripheral region is thin, the pulling force change in the peripheral region does not greatly affect the middle region. Due to the pulling force change in the peripheral region, a lateral pulling force generated in the peripheral region can only be automatically and linearly stretched in the peripheral region, or even if micro-cracking occurs, linear micro-cracking is confined in the peripheral region without directly propagating to the middle region, thereby ensuring the lateral transport performance of the cell.

In an embodiment, at least referring to FIG. 7, the first transparent electrode pattern 11 is close to an edge of the first gap W1, and an edge B1 of the first transparent electrode pattern 11 in a direction perpendicular to a direction in which the first region Q1 extends toward the second region Q2 has a wavy shape.

The second transparent electrode pattern 21 is close to an edge of the first gap W1, and an edge B2 of the second transparent electrode pattern 21 in the direction perpendicular to the direction in which the first region Q1 extends toward the second region Q2 has a wavy shape.

At least as shown in FIG. 7, the direction in which the first region Q1 extends toward the second region Q2 is an X-axis direction, and the direction perpendicular to the direction in which the first region Q1 extends toward the second region Q2 is a Y-axis direction.

In another example, as shown in any one of FIG. 1, FIG. 6, and FIG. 20, only the edge B1 of the first transparent electrode pattern 11 has a wavy shape. In another example, only the edge B2 of the second transparent electrode pattern 21 has a wavy shape.

The wavy shape may be an irregular curve. Through the foregoing arrangement solution, the edge of the transparent electrode pattern layer is disposed to have a wavy shape, so that stress in the edge of the transparent electrode pattern can be reduced, and micro-cracking of the transparent electrode pattern caused by a stress change in the silicon substrate on the edge can be kept from affecting lateral transport performance.

In an embodiment, at least as shown in FIG. 30, the first semiconductor layer and the silicon substrate that are adjacent define a first groove, the second region Q2 is a groove region, a valley portion of a bottom textured surface of the groove region is provided with TCO islands 22, and the TCO islands 22 are away from the climbing portion P and are isolated from the climbing portion P.

When the front surface of the silicon substrate is being textured, the texturing may be synchronously performed on the second region Q2 of the back surface of the silicon substrate.

Through the foregoing arrangement solution, the TCO islands 22 are disposed in the valley portion of the bottom textured surface of the groove of the second region. In one aspect, the TCO islands 22 are not electrically connected to the second transparent electrode pattern 21, thereby ensuring an isolation effect and preventing leakage. In another aspect, the TCO islands 22 fill the valley of the textured surface, so that the surface of the back surface of the cell is flatter, and the reflectivity of the back surface is improved, thereby improving the photoelectric conversion effect.

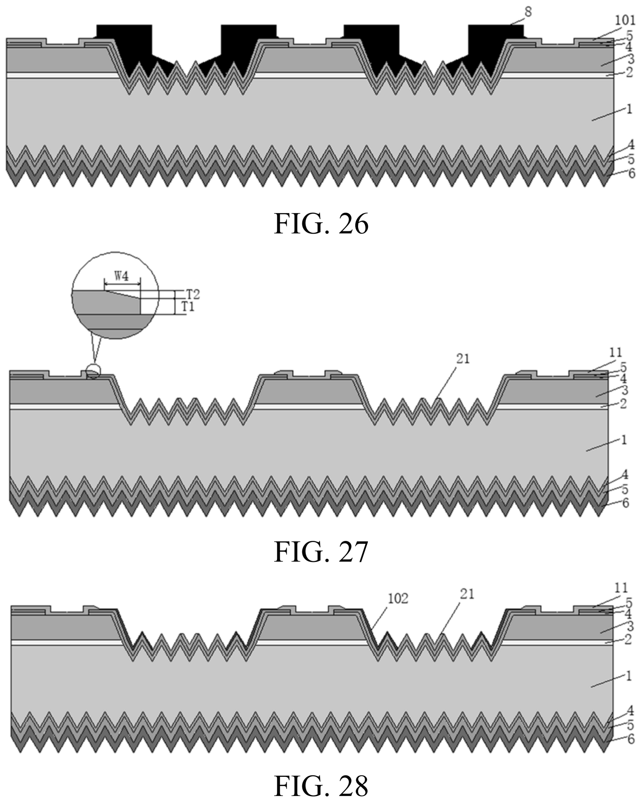

As a feasible implementation, at least as shown in FIG. 28, an isolating protective layer 102 is disposed at a position of the second semiconductor layer that is located on the first gap W1. Alternatively, an isolating protective layer 102 is disposed at each of positions of the climbing portion P and the covering portion G of the second semiconductor layer. Alternatively, an isolating protective layer 102 is disposed at each of a position of the second semiconductor layer that is located on the first gap W1 and at positions of the climbing portion P and the covering portion G of the second semiconductor layer. The isolating protective layer 102 can prevent a problem that in a process of manufacturing the back contact cell in the solution of the present application, metal ions are scattered in the second semiconductor layer and/or the climbing portion P and the covering portion G of the first gap W1, causing damage of the passivation layer in this region and severely affecting the performance of the cell.

As a feasible implementation, the isolating protective layer 102 is a silicon oxide layer or an ink layer.

By way of example without constituting any limitation, a silicon oxide layer used as the isolating protective layer 102 may be formed through deposition. The ink layer used as the isolating protective layer 102 may be formed through printing.

As a feasible implementation, a thickness-reduced region is disposed in the peripheral region of the first transparent electrode pattern 11, and a thickness of the thickness-reduced region gradually decreases from a middle region of the first transparent electrode pattern 11 to an outer boundary of the first transparent electrode pattern 11.

As a feasible implementation, further referring to at least FIG. 19 and FIG. 27, a side of the first transparent electrode pattern 11 that is close to the first gap W1 has a thickness-reduced region, the thickness-reduced region is the first thickness-reduced region S1, a width W4 of the first thickness-reduced region S1 ranges from 10 µm to 50 µm, a thickness T1 of an edge of the first thickness-reduced region S1 that is close to the first gap W1 ranges from 45 nm to 65 nm, and a maximum thinning amount T2 of the first thickness-reduced region S1 ranges from 3 nm to 15 nm.

In an embodiment, the first semiconductor layer includes a tunneling layer 2 disposed on the silicon substrate, and an N-type doped polycrystalline silicon layer is disposed on a side of the tunneling layer 2 that faces away from the silicon substrate.

A material of the tunneling layer 2 is, for example, but not limited to, silicon dioxide. To be specific, the tunneling layer 2 is a tunneling silicon dioxide layer, and the thickness of the tunneling layer 2 may range from 1 nm to 4 nm, and range from 1 nm to 1.8 nm in some embodiments.

The polycrystalline silicon may be doped with phosphor, arsenic, antimony, selenium, tellurium, or another material to form the N-type doped polycrystalline silicon layer. A thickness of the N-type doped polycrystalline silicon layer ranges from 30 nm to 250 nm. In this example, phosphor doping is used, and a phosphor doping concentration in the N-type doped polycrystalline silicon layer ranges from 8E19 cm⁻³ to 5E20 cm⁻³, and ranges from 3E20 cm⁻³ to 9E20 cm⁻³ in some embodiments.

The tunneling layer 2 is disposed on the polished back surface of the silicon substrate. To be specific, the tunneling layer 2 is disposed on a polished surface, thereby improving the deposition uniformity of the tunneling layer 2. In addition, the thickness of the tunneling layer is small, and generally ranges from 1 nm to 4 nm, and ranges from 1 nm to 1.8 nm in some embodiments. If the surface of the silicon substrate has high textured surface fluctuations, the fluctuations are not beneficial to the deposition uniformity of the tunneling layer 2. In addition, in a subsequent polycrystalline annealing process, an uneven surface further deteriorates the nonuniformity at a high temperature, and interacts with an uneven textured surface. A textured surface pyramid tip generates a bare silicon substrate surface with a cliff, affecting the tunneling effect of the cell. However, in this solution, the surface of the silicon substrate is polished to be flatter to improve the uniformity of the tunneling layer 2, thereby improving the tunneling passivation effect and reducing a recombination loss.

The second semiconductor layer includes an intrinsic amorphous silicon layer, and a P-type doped microcrystalline silicon layer is disposed on a side of the intrinsic amorphous silicon layer that faces away from the silicon substrate.

The microcrystalline silicon may be doped with boron, aluminum, gallium, indium, beryllium, magnesium or another material to form the P-type doped microcrystalline silicon layer. In this example, boron doping is used, and a boron doping concentration in the P-type doped microcrystalline silicon layer ranges from 10E20 cm⁻³ to 10E21 cm⁻³.

The thickness of the intrinsic amorphous silicon layer ranges from 10 nm to 20 nm, and the thickness of the P-type doped microcrystalline silicon layer ranges from 5 nm to 45 nm, and ranges from 10 nm to 20 nm in some embodiments.

Through the foregoing arrangement solution, in one aspect, the tunneling layer 2 and the N-type polycrystalline silicon layer are arranged, so that the electrical conduction performance of the first semiconductor layer is improved, and the electrical conduction performance of the polycrystalline silicon is stronger. In another aspect, the intrinsic amorphous silicon layer and the doped microcrystalline silicon layer are disposed, so that a low-temperature process can be used, thereby reducing process complexity. In addition, the low-temperature process does not affect the performance of the tunneling layer and the N-type polycrystalline silicon layer in the previous step, and the impact of impurity diffusion of a doped element caused by a secondary high temperature is avoided. Third, the intrinsic amorphous silicon layer extends to the first semiconductor layer to form the covering portion G, to further passivate the surface of the N-type polycrystalline silicon layer, thereby reducing recombination. Meanwhile, the P-type doped microcrystalline silicon layer is disposed. On the intrinsic amorphous silicon layer, due to the isolation and passivation effects of the intrinsic amorphous silicon layer and the electrical conductivity of the low-temperature P-type doped microcrystalline silicon layer, the current breakdown, short circuit, and leakage between the P and N-type semiconductor layers are prevented.

The climbing portion P covers the first semiconductor layer including microcrystalline silicon. Therefore, the lateral transport is weak, and the quality of a film formed by depositing microcrystalline silicon at a position having a high-low climbing structure deteriorates, which further deteriorates the electrical conductivity of the first semiconductor layer at the climbing structure, thereby further improving the anti-leakage effect between the first region and the second region. As the anti-leakage effect improves, the conversion efficiency of the back contact cell is correspondingly improved.

In addition, the second gap W2 is disposed between the second transparent electrode pattern 21 and the climbing portion P. Because the second semiconductor layer includes microcrystalline silicon, a position at which the microcrystalline silicon is in direct contact with the second transparent electrode pattern 21 has good electrical conduction performance. No electric transport of the transparent electrode pattern exists in the second gap W2. Because microcrystalline silicon has poor lateral electrical conductivity, leakage current between the first transparent electrode pattern 11 and the second transparent electrode pattern 21 is weakened.

In an embodiment, a textured surface is disposed on the front surface of the silicon substrate, and an intrinsic amorphous silicon layer is disposed on the textured surface, or an aluminum oxide layer is disposed on the textured surface.

Through the foregoing arrangement solution, the front surface of the silicon substrate can be passivated to reduce recombination. In another aspect, the front intrinsic amorphous silicon layer and the aluminum oxide layer have stable performance, so that the service life of the cell can be prolonged.

In an embodiment, an anti-reflection layer is disposed on a surface of the intrinsic amorphous silicon layer that faces away from the silicon substrate, or an anti-reflection layer is disposed on a surface of the aluminum oxide layer that faces away from the silicon substrate.

Through the foregoing arrangement solution, the reflection of sunlight is reduced, and the utilization of sunlight is improved, so that the conversion efficiency of the back contact cell can be improved.

In an embodiment, as shown in FIG. 8, the climbing portion P is disposed obliquely relative to the back surface of the silicon substrate, and an inclination angle α of the climbing portion P relative to the back surface of the silicon substrate ranges from 5° to 80° in some embodiments, for example, but not limited to, 5°, 9°, 11°, 15°, 20°, 30°, 40°, 45°, 50°, 53°, 58°, 65°, 70°, or 80°, and ranges from 30° to 70° in some embodiments.

Through the foregoing arrangement solution, the climbing portion P is obliquely disposed on the back surface of the silicon substrate, thereby improving the uniformity of depositing intrinsic amorphous silicon, and improving the passivation effect on the semiconductor substrate. In addition, because the deposited intrinsic amorphous silicon layer has good uniformity and better conformality of surface topography, the deposition and manufacturing of the doped amorphous silicon layer is facilitated, and a doped amorphous silicon layer having good electrical performance is formed, thereby also improving the conversion efficiency of the cell.

In an embodiment, at least further referring to FIG. 7, when the first transparent electrode pattern 11 is disposed on a portion of the bare first semiconductor region and a portion of the covering portion G,
an edge B1 of the first transparent electrode pattern 11 in a direction perpendicular to a direction in which the first region Q1 extends toward the second region Q2 has a wavy shape. The wavy shape may be an irregular curve.

Through the foregoing arrangement solution, the edge of the transparent electrode pattern layer is disposed to have a wavy shape, so that stress in the edge of the transparent electrode pattern can be reduced, and micro-cracking of the transparent electrode pattern caused by a stress change in the silicon substrate on the edge can be kept from affecting lateral transport performance.

In an embodiment, at least further referring to FIG. 7, when the second transparent electrode pattern 21 is disposed on a portion of the second semiconductor layer, a portion of the climbing portion, and a portion of the covering portion G above an orthographic projection of the second region Q2, an edge B2 of the second transparent electrode pattern 21 in a direction perpendicular to a direction in which the first region Q1 extends toward the second region Q2 has a wavy shape. The wavy shape may be an irregular curve.

Through the foregoing arrangement solution, the edge of the transparent electrode pattern layer is disposed to have a wavy shape, so that stress in the edge of the transparent electrode pattern can be reduced, and micro-cracking of the transparent electrode pattern caused by a stress change in the silicon substrate on the edge can be kept from affecting lateral transport performance.

The SEM micrograph stands for a scanning electron micrograph. In an embodiment, refer to FIG. 31 and FIG. 32. FIG. 32 is a partial enlarged view of R in FIG. 31. A curve in FIG. 32 is a boundary line between the first region Q1 and the second region Q2. The boundary line is formed due to laser etching. It is observed in the enlarged view that the boundary line is a curve instead of a straight line. In addition, a width between two straight lines is W1, and the two straight lines are respectively boundary lines between the first transparent conductive layer and the second transparent conductive layer, and play a role of isolation and insulation. A region from the curve to the dashed line in the first region may be understood as the climbing portion P. It may be learned that the second transparent conductive layer covers a region J4 on the left side of the curve. This region belongs to the region Q1. The region Q1 includes the first semiconductor layer, the second semiconductor layer, and the second transparent conductive layer that are stacked. Through the stacked structure, current can be conducted in a case in which a stacked structure is partially shaded by a solar cell, thereby preventing a hot spot of the cell.

According to a second aspect, the present application provides a method for manufacturing any foregoing back contact cell, including the following steps:
providing a cell precursor, where the cell precursor includes a silicon substrate, and the silicon substrate includes a front surface and a back surface; a plurality of first regions and a plurality of second regions are sequentially and alternately disposed on the back surface of the silicon substrate, a first semiconductor layer is disposed on each of the first regions, and a second semiconductor layer is disposed on each of the second regions; and the second semiconductor layer extends toward the first region relative to the second region, and sequentially includes a climbing portion and a covering portion, and the covering portion covers a portion of the first semiconductor layer;
forming a transparent electrode thin film on the back surface of the cell precursor; and
correspondingly etching a portion of the second semiconductor layer, a portion of the climbing portion P, and a portion of the covering portion G close to the climbing portion P on the transparent electrode thin film above the orthographic projection of the second region to etch the transparent electrode thin film to form a first transparent electrode pattern 11 and a second transparent electrode pattern 21 that are isolated.

The following describes embodiments of the present application in detail. It should be noted that the embodiments described below are exemplary, and are merely used for explaining the present application, but cannot be construed as a limitation to the present application. In addition, if not explicitly stated, all the agents used in the following embodiments are commercially available, or can be synthesized according to methods herein or known methods, and are also easily obtained by persons skilled in the art for the unlisted reaction conditions.

### Embodiment 1

This embodiment provides a back contact cell, and a method for manufacturing same includes the following steps.

S1: As shown in FIG. 9 and FIG. 10, provide an N-type silicon substrate 1, and at least polish a front surface and a back surface of the N-type silicon substrate 1 using a wet polishing process.

The N-type silicon substrate 1 needs to be cleaned before polishing to remove impurities, particles, and organic materials on the surface. Generally, cleaning may be performed in a plurality of steps by using deionized water, an alkaline solution (for example, sodium hydroxide NaOH) and an acidic solution (for example, dilute nitric acid HNO₃).

By way of example without constituting any limitation, an N-type silicon substrate 1 is placed in tank-type alkaline polishing equipment to perform polishing and cleaning. The working volume of the tank of the cleaning machine is 360 L. First, the N-type silicon substrate 1 is pre-cleaned to remove organic and other contaminants generated during the cutting and transportation of the N-type silicon substrate 1. In this embodiment, Solution 1 of standard RCA cleaning is used for cleaning (SC-1), and Solution 1 consists of NH₄OH-H₂O₂-H₂O with a volume ratio of 1:1:5. The temperature during cleaning is 65°C. Cleaning using the SC-1 agent is mainly performed through alkaline oxidation to remove particles on a silicon wafer, and oxidation and removal may be performed on small quantities of organic materials on the surface and metal atomic contaminants such as Au, Ag, Cu, Ni, Cd, Zn, Ca, or Cr. After residual chemicals are rinsed away, alkaline polishing is performed. The formula for the alkaline polishing is a solution of 5.97% wt KOH at a temperature of 80°C, and the duration of the alkaline polishing is 300 s, to perform damage removal and polishing. SC1 cleaning, ozone cleaning, and finally acid wash dehydration are then performed to complete polishing and cleaning. After the polishing, a polishing surface of the silicon wafer has a plurality of bases with unit cell residues, and a maximum distance between any two bases ranges from 4 µm to 6 µm. For example, a concentration of the polishing liquid, a temperature, and a polishing time may be controlled to regulate the size of a residue base after polishing.

S2: In a Low Pressure Chemical Vapor Deposition (LPCVD) device, perform thermal oxidation on the N-type silicon substrate 1 to form a tunneling layer 2 of a silicon oxide material on a front surface and a back surface of the N-type silicon substrate 1, and a thickness of the tunneling layer 2 may be 1 nm to 5 nm, for example, 1 nm, 1.5 nm, 1.8 nm, 2 nm, 2.3 nm, 2.6 nm, 3 nm, 3.5 nm, 4 nm, 4.7 nm, or 5 nm. An intrinsic polycrystalline silicon layer is deposited on each tunneling layer 2. Apart from the LPCVD, the intrinsic polycrystalline silicon layer may alternatively be deposited through plasma enhanced chemical vapor deposition (PECVD), physical vapor deposition (PVD), and plasma enhanced atomic layer deposition (PEALD) to implement the manufacturing of the tunneling layer 2 and the intrinsic or in-situ doped poly Si. In some embodiments, the tunneling layer 2 and the polycrystalline silicon (poly) layer are deposited at a high temperature of 600°C to 800°C using the LPCVD. An intrinsic a-si:H+a-si:H(N) film layer in an existing structure of an HBC cell mostly uses expensive CVD equipment for deposition. However, in the present application, the expensive CVD equipment is replaced with inexpensive LPCVD equipment, thereby effectively reducing equipment investment costs.

In a process of forming the tunneling layer 2 and the intrinsic polycrystalline silicon layer, a specific amount of silicon dioxide and intrinsic polycrystalline silicon is peripherally plated on a side surface of the N-type silicon substrate 1.

It should be noted that various types of peripheral plating are not shown in the accompanying drawings.

S3: Separately perform phosphor diffusion on the intrinsic amorphous silicon layer 4 on the front surface and the back surface of the N-type silicon substrate 1 to form an N-type polycrystalline silicon layer 3. A phosphor doping concentration ranges from 8E19 cm⁻³ to 5E20 cm⁻³ (for example, may be 8E19/9E19/1E20/2E20/3E20/4E20/5E20 cm⁻³).

Phosphor diffusion may be performed in a tubular furnace.

In a process of phosphor diffusion, a phosphosilicate glass (PSG) layer is formed on the surface of the N-type polycrystalline silicon layer, and PSG is peripherally plated on a side surface.

S4: Remove the front surface, the back surface, and the peripherally plated PSG.

By way of example without constituting any limitation, in a tank-type cleaning device, PSG may be removed using hydrofluoric acid.

S5: Deposit a hydrogenated silicon nitride layer 7 (SiNₓ:H) on the N-type polycrystalline silicon layer on the back surface.

For example, the hydrogenated silicon nitride layer 7 may be deposited in tubular PECVD equipment. The hydrogenated silicon nitride layer 7 may be used as a mask in a subsequent process. When laser photoresist patterning is performed subsequently, the hydrogenated silicon nitride layer 7 is used as a laser energy absorbing layer, and has a function of reducing impact of the laser film opening process on a passivation effect of the N region, and further has a function of providing a hydrogen source to further passivate the polycrystalline silicon and the silicon substrate, thereby improving the passivation effect, and protecting the N-type doped polycrystalline silicon layer 3 from alkaline corrosion in a texturing process. The thickness of the hydrogenated silicon nitride layer 7 may range from 50 nm to 110 nm. A deposition temperature of the hydrogenated silicon nitride layer 7 may range from 400°C to 600°C.

Hydrogenated silicon nitride is peripherally plated on at least the N-type polycrystalline silicon layer 3 on the front surface.

S6: Perform photoresist patterning on the hydrogenated silicon nitride layer 7 within a range of the second region Q2 to form a mask.

For example, a laser etching manner may be used to remove the hydrogenated silicon nitride layer 7 within the range of the second region Q2. In some examples, after the hydrogenated silicon nitride layer 7 within the range of the second region Q2 is removed, etching continues to be performed downward to remove a portion of the N-type polycrystalline silicon layer on the back surface through etching. In some other examples, alternatively, after the hydrogenated silicon nitride layer 7 within the range of the second region Q2 is removed, etching continues to be performed downward until the surface of the N-type silicon substrate 1 is etched. To be specific, both the N-type polycrystalline silicon layer and the tunneling layer 2 within the range of the second region Q2 are removed.

In this example, an example in which the N-type polycrystalline silicon layer on the back surface is removed through etching is used.

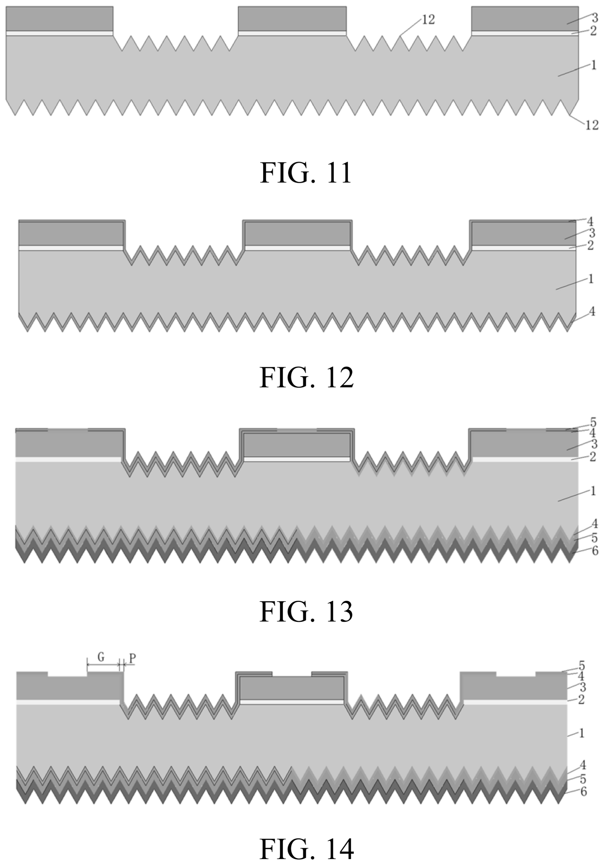

S7: As shown in FIG. 11, separately perform texturing on the front surface and the back surface of the N-type silicon substrate 1.

The front surface of the N-type silicon substrate 1 is completely textured, and the back surface is textured only within the range of the second region Q2, to form a pyramid light-trapping structure, i.e., a textured surface structure 12, at a corresponding position.

Before the texturing, cleaning is first performed using hydrofluoric acid to remove the hydrogenated silicon nitride layer 7 that remains after the laser photoresist patterning, the tunneling layer 2 and the N-type polycrystalline silicon layer 3 in the second region, and the tunneling layer 2 and the N-type polycrystalline silicon layer 3 on the front surface of the N-type silicon substrate 1.

A potassium hydroxide solution with a concentration of 0.8% to 1.2% is used to perform texturing. For example, a potassium hydroxide solution with a mass fraction of 0.8%, 0.9%, 0.95%, 1%, 1.2%, or the like is used as a texturing additive in a tank-type cleaning machine to perform the texturing on the N-type silicon substrate 1 to form textured surfaces on the front surface of the N-type silicon substrate 1 and the second region Q2 on the back surface of the N-type silicon substrate 1.

The hydrogenated silicon nitride peripherally plated on the front surface of the N-type silicon substrate 1 may be removed after the texturing is completed. However, it may be determined, according to an actual case, whether to keep hydrogenated silicon nitride peripherally plated on the side surface.

S8: As shown in FIG. 12, deposit the intrinsic amorphous silicon layer 4 on each of a front surface and a back surface of a component formed after the texturing.

The intrinsic amorphous silicon layer 4 is deposited on each of the front surface and the back surface using plate-type PECVD equipment. The intrinsic amorphous silicon layer 4 may be first disposed on the front surface, and then the intrinsic amorphous silicon layer 4 is disposed on the back surface. Alternatively, the intrinsic amorphous silicon layer 4 may be first deposited on the back surface, and then the intrinsic amorphous silicon layer 4 is deposited on the front surface. When the intrinsic amorphous silicon layer 4 is disposed, the intrinsic amorphous silicon layer 4 is peripherally plated on only a portion of the side surface, and is not peripherally plated on an opposite surface of the current deposition surface.

S9: As shown in FIG. 13, deposit a P-type microcrystalline silicon layer 5 on each of the front surface and the back surface of the component formed in step S8, and deposit a SiNₓ anti-reflection layer 6 on the P-type microcrystalline silicon layer 5 on the front surface.

SiNₓ is peripherally plated on the back surface and the side surface, and the P-type amorphous silicon exists on the side surface.

S10: As shown in FIG. 14, perform photoresist patterning on the intrinsic amorphous silicon layer 4 and the P-type microcrystalline silicon layer 5 in the first region Q1 until the N-type polycrystalline silicon layer 3 is exposed.

For example, a laser etching manner may be used to perform photoresist patterning on the intrinsic amorphous silicon layer 4 and the P-type microcrystalline silicon layer 5 in the first region Q1. After photoresist patterning, the second semiconductor layer is formed on the second region Q2, extends toward the first region Q1 relative to the second region, and sequentially includes a climbing portion P and a covering portion G, and the covering portion G covers a portion of the first semiconductor layer to form a bare first semiconductor region and a covered first semiconductor region.

S11: After photoresist patterning ends, remove SiNₓ peripherally plated on the back surface and the oxide, residues, and the like that remain in a patterned region through a wet etching process.

For example, the SiNₓ peripherally plated on the back surface and the oxide, residues, and the like that remain in the patterned region may be etched using a chain-type pickling machine.

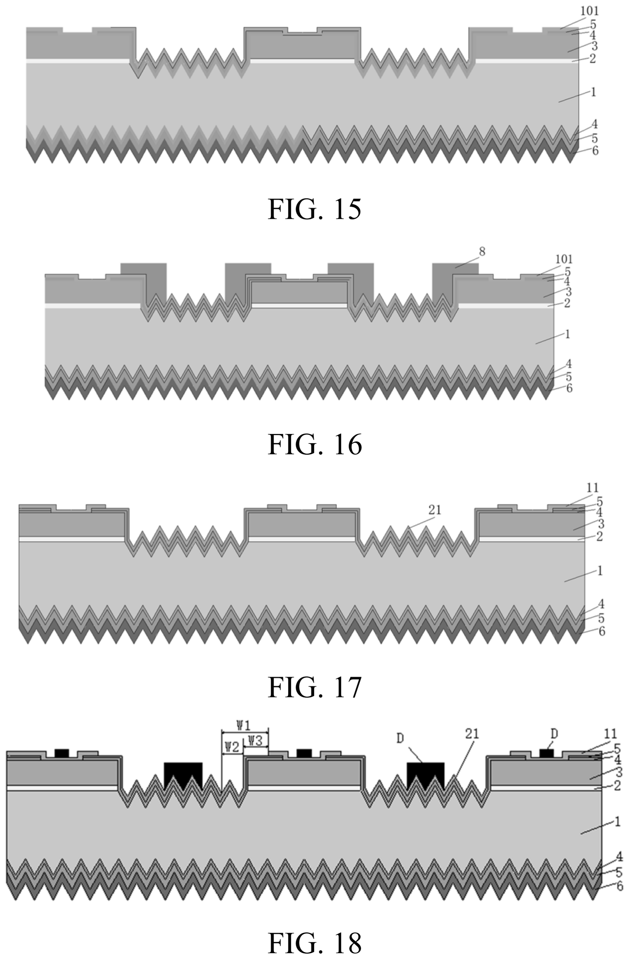

S12: As shown in FIG. 15, after the wet etching process, deposit a transparent conductive thin film 101 on the back surface.

A material of the transparent conductive thin film 101 is, for example, ITO. A thickness of the transparent conductive thin film 101 may range from 10 nm to 300 nm, for example, 10 nm, 20 nm, 35 nm, 40 nm, 60 nm, 85 nm, 100 nm, 110 nm, 130 nm, 150 nm, 180 nm, 210 nm, 240 nm, 270 nm, or 300 nm.

S13: As shown in FIG. 16, disconnect the transparent conductive thin film 101 at a boundary between the first region Q1 and the second region Q2 to form the first transparent electrode pattern 11 and the second transparent electrode pattern 21, where each of the first transparent electrode pattern 11 and the second transparent electrode pattern 21 is an integral structure.

For example, sticky etching paste 8 containing phosphoric acid is formed at the climbing portion at the boundary between the first region Q1 and the second region Q2 through screen printing, and the etching paste 8 is cured to avoid excessive flow of the etching paste in an etching process, so that the etching paste 8 disconnects the transparent conductive thin film 101 to form the first transparent electrode pattern 11 and the second transparent electrode pattern 21. The first transparent electrode pattern 11 is disposed on the whole layer of the bare first semiconductor region and on the portion of the covering portion G in the direction perpendicular to the direction in which the first region Q1 extends toward the second region, or the first transparent electrode pattern 11 is disposed on the portion of the bare first semiconductor region and the portion of the covering portion G. The second gap W2 and the third gap W3 are formed after the etching of the transparent conductive thin film 101 ends. In a cross-section, for example, but not limited to, a plane parallel to the cross-section A-A, the second gap W2 is 20 µm, and the third gap W3 is 50 µm. The dimensions of the second gap W2 and the third gap W3 in the following different examples correspond to those at the same cross-sectional position in the example.

The transparent conductive thin film 101 is disconnected by the etching paste 8 to form the first transparent electrode pattern 11 and the second transparent electrode pattern 21. Compared with that the transparent conductive thin film 101 is disconnected through laser etching or photolithography etching, this solution can effectively disconnect the transparent conductive thin film 101, thereby reducing a problem that a residual transparent conductive material exists and leakage current is large due to laser etching of the transparent conductive thin film 101, and also solving a problem that a production process of a cell is long, difficulty is high in managing a production process, and production capacity and costs are limited, and large-scale production cannot be met because several processes need to be performed on the photolithography etching such as dry film lamination, exposure, development, etching, and dry film removal.

S14: As shown in FIG. 17, remove a residue of the etching paste 8.

For example, the residue of the etching paste 8 is removed through wet alkaline etching. When the etching paste 8 is removed through wet alkaline etching, the first transparent electrode pattern 11 and the second transparent electrode pattern 21 are not affected.

S15: As shown in FIG. 18, form an electrode D on the first transparent electrode pattern 11 and the second transparent electrode pattern 21.

Through screen printing, metal slurry is printed on the first transparent electrode pattern 11 and the second transparent electrode pattern 21, and the metal slurry is cured to form a corresponding electrode.

The electrode may alternatively be formed using ink-jet printing, laser transfer printing, chemical plating, electroplating, or a PVD method.

The tunneling layer 2 and the N-type polycrystalline silicon layer 3 are formed at a high temperature of 600°C to 800°C, and are located on the polished surface of the N-type silicon substrate 1. Therefore, the contact interface between the electrode in the first region and the N-type polycrystalline silicon layer 3 is in smooth surface contact. Moreover, the smooth surface structure of the N-type polycrystalline silicon layer 3 formed in a high-temperature environment can ensure a passivation effect of the tunneling layer 2. Because a high-temperature process is performed, the film layer has enhanced adhesion density and a strong binding force with the electrode. However, the intrinsic amorphous silicon layer 4 and the P-type microcrystalline silicon layer 5 in the second region do not go through a high-temperature process of the tunneling layer 2 and the N-type polycrystalline silicon layer 3 in the first region, the electrode is connected to the P-type microcrystalline silicon layer 5, and a connection effect needs to be improved. A simple smooth surface structure has a small contact area, which is not beneficial to the adhesion of the electrode. Therefore, a textured surface structure is disposed in the second region, which increases a specific surface area of a contact surface, and improves the adhesion of the electrode to the P-type microcrystalline silicon layer 5.

### Embodiment 2

This embodiment provides a back contact cell. A difference between this embodiment and Embodiment 1 is mainly provided below.

On the front surface of the N-type silicon substrate 1, the P-type microcrystalline silicon layer 5 is not disposed between the intrinsic amorphous silicon layer 4 and the SiNₓ anti-reflection layer 6.

### Embodiment 3

This embodiment provides a back contact cell. Differences between this embodiment and Embodiment 1 are mainly provided below.

S8: On the front surface of the N-type silicon substrate 1, replace the intrinsic amorphous silicon with aluminum oxide, where aluminum oxide may be deposited through ALD, and aluminum oxide is peripherally plated on the side face.

S9: Deposit a SiNₓ anti-reflection layer on the front surface of the component formed in step S8, where SiNₓ is peripherally plated on the back surface and the side surface.

S10: Deposit the intrinsic amorphous silicon and the P-type doped microcrystalline silicon on the back surface of the component after S9 is completed, then perform photoresist patterning on the intrinsic amorphous silicon layer 4 and the P-type microcrystalline silicon layer 5 in the first region Q1 until the N-type polycrystalline silicon layer 3 is exposed, and form the intrinsic amorphous silicon and the P-type doped microcrystalline silicon covering the second region and a portion of the intrinsic amorphous silicon and the P-type doped microcrystalline silicon extending to the first region, to form the climbing portion and the covering portion.

### Embodiment 4

This embodiment provides a back contact cell. A difference between this embodiment and Embodiment 1 is mainly provided below.

A width of the second gap W2 is 10 µm, and a width of the third gap W3 is 50 µm.

### Embodiment 5

This embodiment provides a back contact cell. A difference between this embodiment and Embodiment 1 is mainly provided below.

A width of the second gap W2 is 20 µm, and a width of the third gap W3 is 60 µm.

### Embodiment 6

This embodiment provides a back contact cell. A difference between this embodiment and Embodiment 1 is mainly provided below.

A width of the second gap W2 is 20 µm, and a width of the third gap W3 is 70 µm.

### Embodiment 7

This embodiment provides a back contact cell. A difference between this embodiment and Embodiment 1 is mainly provided below.

A width of the second gap W2 is 30 µm, and a width of the third gap W3 is 60 µm.

### Embodiment 8

This embodiment provides a back contact cell. A difference between this embodiment and Embodiment 2 is mainly provided below.

A width of the second gap W2 is 30 µm, and a width of the third gap W3 is 70 µm.

### Embodiment 9

This embodiment provides a back contact cell. A difference between this embodiment and Embodiment 2 is mainly provided below.

A width of the second gap W2 is 30 µm, and a width of the third gap W3 is 80 µm.

### Embodiment 10

This embodiment provides a back contact cell. A difference between this embodiment and Embodiment 2 is mainly provided below.

A width of the second gap W2 is 40 µm, and a width of the third gap W3 is 80 µm.

### Comparative example 1

This comparative example provides a back contact cell, and a method for manufacturing same includes the following steps.

S1: Provide an N-type silicon substrate 1, and at least polish a front surface and a back surface of the N-type silicon substrate 1 using a wet polishing process.

The N-type silicon substrate 1 needs to be cleaned before polishing to remove impurities, particles, and organic materials on the surface. Generally, cleaning may be performed in a plurality of steps by using deionized water, an alkaline solution (for example, sodium hydroxide NaOH) and an acidic solution (for example, dilute nitric acid HNO₃).

By way of example without constituting any limitation, an N-type silicon substrate 1 is placed in tank-type alkaline polishing equipment to perform polishing and cleaning. The working volume of the tank of the cleaning machine is 360 L. First, the N-type silicon substrate 1 is pre-cleaned to remove organic and other contaminants generated during the cutting and transportation of the N-type silicon substrate 1. In this embodiment, Solution 1 of standard RCA cleaning is used for cleaning, and Solution 1 consists of NH₄OH-H₂O₂-H₂O with a volume ratio of 1:1:5. The temperature during cleaning is 65°C. Cleaning using the SC-1 agent is mainly performed through alkaline oxidation to remove particles on a silicon wafer, and oxidation and removal may be performed on small quantities of organic materials on the surface and metal atomic contaminants such as Au, Ag, Cu, Ni, Cd, Zn, Ca, or Cr. After residual chemicals are rinsed away, alkaline polishing is performed. The formula for the alkaline polishing is a solution of 5.97% wt KOH at a temperature of 80°C, and the duration of the alkaline polishing is 300 s, to perform damage removal and polishing. SC1 cleaning, ozone cleaning, and finally acid wash dehydration are then performed to complete polishing and cleaning. After the polishing, a polishing surface of the silicon wafer has a plurality of bases with unit cell residues, and a maximum distance between any two bases ranges from 4 µm to 6 µm. For example, a concentration of the polishing liquid, a temperature, and a polishing time may be controlled to regulate the size of a residue base after polishing.

S2: In a Low Pressure Chemical Vapor Deposition (LPCVD) device, perform thermal oxidation on the N-type silicon substrate 1 to form a tunneling layer 2 of a silicon oxide material on a front surface and a back surface of the N-type silicon substrate 1, and a thickness of the tunneling layer 2 may be 1 nm to 5 nm, for example, 1 nm, 1.5 nm, 1.8 nm, 2 nm, 2.3 nm, 2.6 nm, 3 nm, 3.5 nm, 4 nm, 4.7 nm, or 5 nm. An intrinsic polycrystalline silicon layer is deposited on each tunneling layer 2. Apart from the LPCVD, the intrinsic polycrystalline silicon layer may alternatively be deposited through PECVD, PVD, PEALD, or the like. Generally, in some embodiments, the tunneling layer 2 and the intrinsic polycrystalline silicon layer are deposited at a high temperature of 600°C to 800°C using LPCVD. Deposition is performed using LPCVD equipment, so that equipment costs and investment can be reduced.

In a process of forming the tunneling layer 2 and the intrinsic polycrystalline silicon layer, a specific amount of silicon dioxide and intrinsic polycrystalline silicon is peripherally plated on a side surface of the N-type silicon substrate 1.

It should be noted that various types of peripheral plating are not shown in the accompanying drawings.

S3: Separately perform phosphor diffusion on the intrinsic amorphous silicon layer 4 on the front surface and the back surface of the N-type silicon substrate 1 to form an N-type polycrystalline silicon layer 3. A phosphor doping concentration ranges from 8E19 cm⁻³ to 5E20 cm⁻³ (for example, may be 8E19/9E19/1E20/2E20/3E20/4E20/5E20 cm⁻³).

Phosphor diffusion may be performed in a tubular furnace.

In a process of phosphor diffusion, a phosphosilicate glass (PSG) layer is formed on the surface of the N-type polycrystalline silicon layer, and PSG is peripherally plated on a side surface.

S4: Remove the front surface, the back surface, and the peripherally plated PSG.

By way of example without constituting any limitation, in a tank-type cleaning device, PSG may be removed using hydrofluoric acid.

S5: Deposit a hydrogenated silicon nitride layer 7 (SiNₓ:H) on the N-type polycrystalline silicon layer on the back surface.

For example, the hydrogenated silicon nitride layer 7 may be deposited in tubular PECVD equipment. The hydrogenated silicon nitride layer 7 may be used as a mask in a subsequent process. When laser photoresist patterning is performed subsequently, the hydrogenated silicon nitride layer 7 is used as a laser energy absorbing layer, and has a function of reducing impact of the laser film opening process on a passivation effect of the N region, and further has a function of providing a hydrogen source to further passivate the polycrystalline silicon and the silicon substrate, thereby improving the passivation effect, and protecting the N-type doped polycrystalline silicon layer 3 from alkaline corrosion in a texturing process. The thickness of the hydrogenated silicon nitride layer 7 may range from 50 nm to 110 nm.

Hydrogenated silicon nitride is peripherally plated on at least the N-type polycrystalline silicon layer 3 on the front surface.

S6: Perform photoresist patterning on the hydrogenated silicon nitride layer 7 within a range of the second region Q2 to form a mask.

For example, a laser etching manner may be used to remove the hydrogenated silicon nitride layer 7 within the range of the second region Q2. In some examples, after the hydrogenated silicon nitride layer 7 within the range of the second region Q2 is removed, etching continues to be performed downward to remove a portion of the N-type polycrystalline silicon layer on the back surface through etching. In some other examples, alternatively, after the hydrogenated silicon nitride layer 7 within the range of the second region Q2 is removed, etching continues to be performed downward until the surface of the N-type silicon substrate 1 is etched. To be specific, both the N-type polycrystalline silicon layer and the tunneling layer 2 within the range of the second region Q2 are removed.

In this example, an example in which the N-type polycrystalline silicon layer on the back surface is removed through etching is used.

S7: Separately perform texturing on the front surface and the back surface of the N-type silicon substrate 1.

The front surface of the N-type silicon substrate 1 is completely textured, and the back surface is textured only within the range of the second region Q2, to form a pyramid light-trapping structure, i.e., a textured surface structure 12, at a corresponding position.

Before the texturing, cleaning is first performed using hydrofluoric acid to remove the hydrogenated silicon nitride layer 7 that remains after the laser photoresist patterning, the tunneling layer 2 and the N-type polycrystalline silicon layer 3 in the second region, and the tunneling layer 2 and the N-type polycrystalline silicon layer 3 on the front surface of the N-type silicon substrate 1.

A potassium hydroxide solution with a concentration of 0.8% to 1.2% is used to perform texturing. For example, a potassium hydroxide solution with a mass fraction of 0.8%, 0.9%, 0.95%, 1%, 1.2%, or the like is used as a texturing additive in a tank-type cleaning machine to perform the texturing on the N-type silicon substrate 1 to form textured surfaces on the front surface of the N-type silicon substrate 1 and the second region Q2 on the back surface of the N-type silicon substrate 1.

After texturing ends, cleaning may be separately performed in an SC1 cleaning tank, a CP smoothing tank, an SC2 cleaning tank, and a pickling tank. The function of the SC1 cleaning tank is mainly to remove contaminants and chemical residues on the surface of an intermediate component. The function of the CP smoothing tank is to smoothen a pyramid tip and a valley bottom, to prevent the deposition and epitaxial growth of amorphous silicon. The function of the SC2 cleaning tank is to remove metal residues of the N-type silicon substrate 1. The function of the pickling tank is to complete the chemical passivation of the intermediate component and form a hydrophobic structure.

The hydrogenated silicon nitride peripherally plated on the front surface of the N-type silicon substrate 1 may be removed after the texturing is completed. However, it may be determined, according to an actual case, whether to keep hydrogenated silicon nitride peripherally plated on the side surface.

S8: Deposit the intrinsic amorphous silicon layer 4 on each of a front surface and a back surface of a component formed after the texturing.

The intrinsic amorphous silicon layer 4 is deposited on each of the front surface and the back surface using plate-type PECVD equipment. The intrinsic amorphous silicon layer 4 may be first disposed on the front surface, and then the intrinsic amorphous silicon layer 4 is disposed on the back surface. Alternatively, the intrinsic amorphous silicon layer 4 may be first deposited on the back surface, and then the intrinsic amorphous silicon layer 4 is deposited on the front surface. When the intrinsic amorphous silicon layer 4 is disposed, the intrinsic amorphous silicon layer 4 is peripherally plated on only a portion of the side surface, and is not peripherally plated on an opposite surface of the current deposition surface.

S9: Deposit a P-type microcrystalline silicon layer 5 on each of the front surface and the back surface of the component formed in step S8, and deposit a SiNₓ anti-reflection layer 6 on the P-type microcrystalline silicon layer 5 on the front surface.

SiNₓ is peripherally plated on the back surface and the side surface, and the P-type amorphous silicon exists on the side surface.

S10: Perform photoresist patterning on the intrinsic amorphous silicon layer 4 and the P-type microcrystalline silicon layer 5 in the first region Q1 until the N-type polycrystalline silicon layer 3 is exposed.

For example, a laser etching manner may be used to perform photoresist patterning on the intrinsic amorphous silicon layer 4 and the P-type microcrystalline silicon layer 5 in the first region Q1.

S11: After photoresist patterning ends, remove SiNₓ peripherally plated on the back surface and the oxide, residues, and the like that remain in a patterned region through a wet etching process.

For example, the SiNₓ peripherally plated on the back surface and the oxide, residues, and the like that remain in the patterned region may be etched using a chain-type pickling machine.

S12: After the wet etching process, deposit a transparent conductive thin film 101 on the back surface.

A material of the transparent conductive thin film 101 is, for example, ITO. A thickness of the transparent conductive thin film 101 may range from 10 nm to 300 nm, for example, 10 nm, 20 nm, 35 nm, 40 nm, 60 nm, 85 nm, 100 nm, 110 nm, 130 nm, 150 nm, 180 nm, 210 nm, 240 nm, 270 nm, or 300 nm.

S13: Disconnect the transparent conductive thin film 101 at a boundary between the first region Q1 and the second region Q2 to form the first transparent electrode pattern 11 and the second transparent electrode pattern 21.

For example, in a manner of laser photoresist patterning, the transparent conductive thin film 101 is disconnected through etching at a climbing portion at a boundary between the first region Q1 and the second region Q2 to form the first transparent electrode pattern 11 and the second transparent electrode pattern 21, and the foregoing second gap W2 and third gap W3 are provided. A width of the second gap W2 is 20 µm, and a width of the third gap W3 is 50 µm. The power of the laser is 28 W.

When the transparent conductive thin film 101 is disconnected through laser etching. Because the energy of the laser is large, a generated high temperature may affect the passivation of the back contact cell, and therefore affect the electrical performance of the back contact cell.

### Comparative example 2

This comparative example provides a back contact cell, and a main difference between this comparative example and Comparative example 1 lies in that the power of the laser is 31 W.

### Comparison example 3

This comparative example provides a back contact cell, and a main difference between this comparative example and Comparative example 1 lies in that the power of the laser is 34 W.

### Comparison example 4

This comparative example provides a back contact cell, and a main difference between this comparative example and Comparative example 1 lies in that the power of the laser is 37 W.

Performance tests are performed on energy conversion efficiency Eta, parallel resistance Rsh, open circuit voltage Voc, fill factors FF, and leakage current I-RV of the back contact cells manufactured in Embodiments 1 to 9 and Comparative examples 1 to 4, and the results are shown in the following table:

| Group | Eta (%) | Rsh (Ω) | Voc (V) | FF | I-RV (-15 V) A |
|---|---|---|---|---|---|
| Embodiment 1 | 25.45 | 77 | 0.745 | 83.6 | 0.22 |
| Embodiment 2 | 25.5 | 100 | 0.745 | 83.7 | 0.25 |
| Embodiment 3 | 25.48 | 50 | 0.746 | 83.6 | 0.3 |
| Embodiment 4 | 25.5 | 120 | 0.745 | 83.4 | 0.2 |
| Embodiment 5 | 25.4 | 130 | 0.746 | 83.3 | 0.25 |
| Embodiment 6 | 25.37 | 150 | 0.745 | 83.4 | 0.2 |
| Embodiment 7 | 25.35 | 180 | 0.746 | 83.2 | 0.18 |
| Embodiment 8 | 25.35 | 200 | 0.745 | 83.1 | 0.15 |
| Embodiment 9 | 25.35 | 220 | 0.746 | 83.2 | 0.15 |
| Embodiment 10 | 25.35 | 210 | 0.746 | 83.2 | 0.17 |
| Comparative example 1 | 25.24 | 20 | 0.744 | 83.2 | 15.5 |
| Comparative example 2 | 25.20 | 30 | 0.744 | 83.2 | 13 |
| Comparison example 3 | 25.15 | 70 | 0.743 | 83.1 | 12 |
| Comparison example 4 | 25.10 | 130 | 0.7425 | 83.0 | 10 |

It can be easily seen from the foregoing that the leakage current in the examples of this solution is far less than that in the comparative examples.

It should be noted that FIG. 10 and FIG. 21 to FIG. 29 show another manufacturing process corresponding to a cross-sectional position E-E in FIG. 9 according to an embodiment of the present application, which is approximately the same as that in Embodiment 1 above. Differences are mainly described below. Referring to FIG. 28, an isolating protective layer 102 is disposed at each of a position of the second semiconductor layer that is located on the first gap W1 and at positions of the climbing portion P and the covering portion G of the second semiconductor layer.

In this example, the ink layer used as the isolating protective layer 102 is formed using printing ink.

In another example, the isolating protective layer 102 may alternatively be disposed at a position of the second semiconductor layer that is located on the first gap W1. Alternatively, the isolating protective layer 102 is disposed at positions of the climbing portion P and the covering portion G of the second semiconductor layer.

It should be understood that orientation or location relationships indicated by terms "center", "vertical", "horizontal", "up", "down", "front", "rear", "left", "right", "vertical", "horizontal", "top", "bottom", "inside", and "outside" described above are based on orientation or location relationships shown in the accompanying drawings, and are only used to facilitate description of the present application and simplify description, but are not used to indicate or imply that the apparatuses or elements must have specific orientations or are constructed and operated by using specific orientations, and therefore, cannot be understood as a limit to the present application. In addition, terms "first" and "second" are used merely for the purpose of description, and shall not be construed as indicating or implying relative importance or implying a quantity of indicated technical features. Therefore, a feature limited by "first" or "second" may explicitly or implicitly include one or more of the features. In the description of the present application, "a plurality of" herein means "two or more" unless otherwise described.

The foregoing description is only the description of preferred embodiments of the present application and the used technical principle. A person skilled in the art should understand that the scope of the application in the present application is not limited to a technical solution formed by a specific combination of the technical features. In addition, other technical solutions formed by any combination of the foregoing technical features or equivalent features thereof shall be encompassed without departing from the application concept. For example, the technical solutions formed by mutual replacement between the foregoing features and the technical features having similar functions (however, the technical features are not limited thereto) disclosed in the present application shall be encompassed.

## Claims

1. A back contact cell, comprising a silicon substrate, wherein the silicon substrate comprises a front surface and a back surface; and a plurality of first regions and a plurality of second regions are sequentially and alternately disposed on the back surface of the silicon substrate, a first semiconductor layer is disposed on each of the first regions, a second semiconductor layer is disposed on each of the second regions,
the first semiconductor layer is connected to a first transparent electrode pattern, the second semiconductor layer is connected to a second transparent electrode pattern, and the first transparent electrode pattern and the second transparent electrode pattern are consistently isolated by a first gap.

2. The back contact cell according to claim 1, wherein the second semiconductor layer extends toward the first region relative to the second region, and sequentially comprises a climbing portion and a covering portion, and the covering portion covers a portion of the first semiconductor layer to form a bare first semiconductor region and a covered first semiconductor region;
the second transparent electrode pattern is disposed on a portion of the second semiconductor layer, a portion of the climbing portion, and a portion of the covering portion above an orthographic projection of the second region; and
the first transparent electrode pattern is disposed on the bare first semiconductor region and a portion of the covering portion in a direction perpendicular to a direction in which the first region extends toward the second region.

3. The back contact cell according to claim 1, wherein the first transparent electrode pattern comprises a first middle region and a first peripheral region surrounding the first middle region, and a thickness of the first peripheral region is less than an average thickness of the first middle region; and/or
the second transparent electrode pattern comprises a second middle region and a second peripheral region surrounding the second middle region, and a thickness of the second peripheral region is less than an average thickness of the second middle region.

4. The back contact cell according to claim 1, wherein the first transparent electrode pattern comprises a first middle region and a first peripheral region surrounding the first middle region, and in a cross-section of the back contact cell, a thickness of the first peripheral region gradually increases along a direction away from an edge of the first peripheral region; and/or
the second transparent electrode pattern comprises a second middle region and a second peripheral region surrounding the second middle region, and in a cross-section of the back contact cell, a thickness of the second peripheral region gradually increases along a direction away from an edge of the second peripheral region.

5. The back contact cell according to claim 1, wherein the first transparent electrode pattern comprises a first middle region and a first peripheral region surrounding the first middle region, a first thickness-reduced region is disposed in the first peripheral region of the first transparent electrode pattern, and a thickness of the first thickness-reduced region gradually decreases from a middle region of the first transparent electrode pattern to an outer boundary of the first transparent electrode pattern; and/or
the second transparent electrode pattern comprises a second middle region and a second peripheral region surrounding the second middle region, a second thickness-reduced region is disposed in the second peripheral region of the second transparent electrode pattern, and a thickness of the second thickness-reduced region gradually decreases from a middle region of the second transparent electrode pattern to an outer boundary of the second transparent electrode pattern.

6. The back contact cell according to claim 2, wherein when the second transparent electrode pattern is disposed on the portion of the second semiconductor layer above the orthographic projection of the second region, a second gap is formed between an edge of the second transparent electrode pattern and the climbing portion in a cross-section of the back contact cell; and optionally, a width of the second gap ranges from 10 micrometers to 80 micrometers, and optionally ranges from 20 micrometers to 50 micrometers.

7. The back contact cell according to claim 6, wherein a third gap is formed between an edge of the first transparent electrode pattern and the climbing portion, and optionally, a width of the third gap ranges from 40 micrometers to 80 micrometers, and optionally ranges from 40 micrometers to 60 micrometers.

8. The back contact cell according to claim 7, wherein a ratio of the width of the third gap to the width of the second gap ranges from 1:1 to 3:1.

9. The back contact cell according to claim 2, wherein a width of the covering portion ranges from 60 micrometers to 200 micrometers, and optionally ranges from 60 micrometers to 80 micrometers.

10. The back contact cell according to claim 7, wherein a ratio of the width of the covering portion to the width of the third gap ranges from 4:3 to 4:2.

11. The back contact cell according to claim 2, wherein a vertical distance between a surface of the covering portion that faces away from the silicon substrate and a position on the silicon substrate is greater than a vertical distance between a surface of the second transparent electrode pattern that faces away from the silicon substrate and a position on the silicon substrate.

12. The back contact cell according to any one of claims 1 to 11, wherein the first semiconductor layer comprises a tunneling layer disposed on the silicon substrate, and an N-type doped polycrystalline silicon layer is disposed on a side of the tunneling layer that faces away from the silicon substrate; and
the second semiconductor layer comprises an intrinsic amorphous silicon layer, and a P-type doped microcrystalline silicon layer is disposed on a side of the intrinsic amorphous silicon layer that faces away from the silicon substrate.

13. The back contact cell according to claim 1, wherein a textured surface is disposed on the front surface of the silicon substrate, and an intrinsic amorphous silicon layer is disposed on the textured surface, or an aluminum oxide layer is disposed on the textured surface.

14. The back contact cell according to claim 13, wherein an anti-reflection layer is disposed on a surface of the intrinsic amorphous silicon layer that faces away from the silicon substrate, or an anti-reflection layer is disposed on a surface of the aluminum oxide layer that faces away from the silicon substrate.

15. The back contact cell according to claim 2, wherein the climbing portion is disposed obliquely relative to the back surface of the silicon substrate, and optionally, an inclination angle of the climbing portion relative to the back surface of the silicon substrate ranges from 5° to 80°, and optionally ranges from 30° to 70°.

16. The back contact cell according to claim 1, wherein the first transparent electrode pattern is close to an edge of the first gap, and an edge of the first transparent electrode pattern in a direction perpendicular to a direction in which the first region extends toward the second region has a wavy shape; and/or
the second transparent electrode pattern is close to an edge of the first gap, and an edge of the second transparent electrode pattern in the direction perpendicular to the direction in which the first region extends toward the second region has a wavy shape.

17. The back contact cell according to claim 2, wherein
an edge of the first transparent electrode pattern on the covering portion in the direction perpendicular to the direction in which the first region extends toward the second region has a wavy shape.

18. The back contact cell according to claim 1, wherein a boundary line between the first region and the second region is a curve.

19. The back contact cell according to claim 2, wherein the first semiconductor layer and the silicon substrate that are adjacent define a first groove, the second region is a groove region, a valley portion of a bottom textured surface of the groove region is provided with TCO islands, and the TCO islands are away from the climbing portion and are isolated from the climbing portion.

20. The back contact cell according to claim 1, wherein a side of the first transparent electrode pattern that is close to the first gap has a thickness-reduced region, a width of the thickness-reduced region ranges from 10 µm to 50 µm, and a thickness of an edge of the thickness-reduced region that is close to the first gap ranges from 45 nm to 65 nm.

21. A method for manufacturing a back contact cell, comprising the following steps:
providing a cell precursor, wherein the cell precursor comprises a silicon substrate, and the silicon substrate comprises a front surface and a back surface; and a plurality of first regions and a plurality of second regions are sequentially and alternately disposed on the back surface of the silicon substrate, a first semiconductor layer is disposed on each of the first regions, and a second semiconductor layer is disposed on each of the second regions;
forming a transparent electrode thin film on the back surface of the cell precursor; and
etching the transparent electrode thin film between the first region and the second region to etch the transparent electrode thin film to form a first transparent electrode pattern and a second transparent electrode pattern that are isolated.
